# EUROPEAN PATENT SPECIFICATION

(11) **EP 0 810 643 B1**
(45) Date of publication and mention of the grant of the patent: **31.08.2005**
(21) Application number: 97303616.3
(22) Date of filing: 28.05.1997
(51) Int. Cl.: H01L 21/306, B08B 3/12, H01L 21/20

(54) **Method for cleaning a porous surface of a semiconductor substrate**
Verfahren zur Reinigung einer porösen Fläche eines Halbleitersubstrats
Méthode de nettoyage d'une surface poreuse d'un substrat semiconducteur

(30) Priority: 28.05.1996 JP 15763296; 05.06.1996 JP 14283696; 05.06.1996 JP 14283796
(43) Date of publication of application: 03.12.1997
(73) Proprietor: CANON KABUSHIKI KAISHA, Tokyo (JP)
(72) Inventor: Fujiyama, Yasutomo, Ohta-ku, Tokyo (JP); Kumomi, Hideya, Ohta-ku, Tokyo (JP)
(74) Representative: Beresford, Keith Denis Lewis

(56) References cited:
- EP-A- 0 502 237
- EP-A- 0 572 211
- US-A- 5 427 977
- PATENT ABSTRACTS OF JAPAN vol. 15, no. 130 (E-1051), 29 March 1991 -& JP 03 014230 A (TOSHIBA CORP.), 22 January 1991,
- PATENT ABSTRACTS OF JAPAN vol. 012, no. 049 (E-582), 13 February 1988 & JP 62 198127 A (SANYO ELECTRIC CO LTD;OTHERS: 01), 1 September 1987,
- PATENT ABSTRACTS OF JAPAN vol. 018, no. 651 (C-1285), 9 December 1994 -& JP 06 254521 A (OLYMPUS OPTICAL CO LTD), 13 September 1994,
- PATENT ABSTRACTS OF JAPAN vol. 16, no. 465 (E-1270), 28 September 1992 & JP 04 165620 A (SONY CORP.), 11 June 1992,
- YONEHARA T ET AL: "EPITAXIAL LAYER TRANSFER BY BOND AND ETCH BACK OF POROUS SI" APPLIED PHYSICS LETTERS, vol. 64, no. 16, 18 April 1994, pages 2108-2110, XP000440703
- O.I. BABIKOV: "Ultrasonic modular units for cleaning semiconductor structures in deionized water with increased intensity of the piezoceramic transducers" ELEKTROTEKHNIKA, vol. 62, no. 6, 1991, pages 74-77, XP002050135
- PATENT ABSTRACTS OF JAPAN vol. 016, no. 420 (E-1259), 4 September 1992 & JP 04 144131 A (TOSHIBA CORP), 18 May 1992,
- PATENT ABSTRACTS OF JAPAN vol. 018, no. 493 (E-1606), 14 September 1994 -& JP 06 168660 A (SONY CORP), 14 June 1994,

## Description

### BACKGROUND OF THE INVENTION

### Field of the Invention

The present invention relates to a cleaning method for cleaning a substrate having porous structure exposed in the surface thereof and, more particularly, to a cleaning method of porous surface suitably applicable as a cleaning method for cleaning a porous silicon semiconductor substrate used for selective etching or dielectric isolation of semiconductor or used as a light emitting material, which demands the most strict control of cleanliness of the surface thereof. The invention also relates to a cleaning method of semiconductor surface.

### Related Background Art

The method for forming the porous structure typified by porous silicon was introduced by A. Uhlir in 1956 (Bell. Syst. Tech. J, 35, pp. 333).

After that, application technologies were developed including use thereof as a selective etching layer or as an isolation area after oxidized, epitaxial growth on porous silicon, etc. The present applicant disclosed in Japanese Laid-Open Patent Application No. 5-21338 that an SOI (Silicon on Insulator) substrate was fabricated using a single-crystal silicon thin film epitaxially grown on porous silicon.

In recent years the photoluminescence phenomenon of porous silicon was discovered, and then it is drawing attention as a self-radiative material utilizing its features of not only the structure but also the physical property.

A popular method for forming porous silicon is anodization in an electrolyte solution of mixture of hydrofluoric acid/pure water/ethanol by the conventional electrochemical cell structure. Since many dust particles adhere to this porous silicon, it is better to remove the dust particles by cleaning before epitaxial growth on the porous silicon. Conventional cleaning was only rinsing the above electrolyte solution inside pores with pure water. Even now there is no example to introduce a positive cleaning method of the surface.

As well known, cleaning is indispensable before and after processing in the semiconductor processes and it is also unavoidable in the case of the porous silicon substrate. The conventional cleaning methods of bulk substrate (non-porous substrate) include chemical wet cleaning with combination of chemicals such as sulfuric acid/hydrogen peroxide, ammonia/hydrogen peroxide, hydrochloric acid/hydrogen peroxide, or hydrofluoric acid/pure water, as typified by RCA cleaning (RCA Review, 31, pp. 187-205, 1970) developed by W. Kern et al., which is said to be a method effective to removal of dust particles on the surface.

Recently, there was proposed a method for removing the dust particles by applying a high-frequency ultrasonic wave of the frequency of about 1 MHz (megasonic wave) to the bulk substrate in a mixture of hydrofluoric acid/hydrogen peroxide/pure water/surfactant or in ozone-added pure water, for the purpose of decreasing amounts of cleaning chemicals.

This method is characterized by cleaning conducted in such a way that the silicon substrate is oxidized with hydrofluoric acid and hydrogen peroxide to be etched, the dust particles on the surface is lifted off from the substrate, and potentials of the dust particles are neutralized with the surfactant to prevent re-deposition of dust particles to the substrate. The combination of megasonic is purposed to give energy upon the lift-off of dust particles and to remove organic matter attached to the surface of substrate by generation of ions from the pure water by megasonic. Thus, the basis of the cleaning is cleaning with the chemicals. Use of the ozone pure water is for the purpose of enhancing the organic removing effect.

In the ultrasonic cleaning, cleaning with low frequencies ranging approximately from several ten kHz to 400 kHz conventionally used is "liquid resonance cleaning" to remove the dust particles of several ten µm on the substrate surface by applying a strong shock wave to the substrate surface by liquid cavitation (expansion/compaction) due to the liquid resonance action. In contrast, cleaning with high frequencies ranging from 800 kHz to 1.6 MHz is "sound-wave scrub cleaning" to remove the dust particles by giving kinetic energy based on resonance to the dust particles, which enables to remove the dust particles of submicron order without damaging fine patterns.

From such characteristics, the low-frequency cleaning had the problem of damage of fine pattern due to the cavitation impact and became unemployed in the semiconductor processes of 4-Mbit DRAM and after. On the other hand, the high-frequency cleaning is drawing attention as a method capable of cleaning the fine dust particles without damaging the patterns.

According to the experience of the present inventors, the substrate having the surface of the porous structure is of fine and dense structure and of structure having long pores. Therefore, use of chemicals in the conventional chemical wet cleaning causes the chemicals to intrude deeply into the inside of pores, which makes perfect elimination of chemicals difficult even with rinsing with pure water for a long time. It negatively affects the post-processes like the epitaxial growth on the porous structure.

If the dust particles are attempted to be physically removed by superposing the conventional ultrasonic of low frequency on pure water, the too fragile property of the porous structure will raise the problem of collapse of porous structure due to sound pressure of shock wave of cavitation even in the relatively high frequency region around 200 kHz.

This problem results from the structure of porous silicon and the experience of the present inventors is not peculiar. The reason why the positive cleaning of porous silicon surface does not have been conducted heretofore can be considered to be based on the same problem.

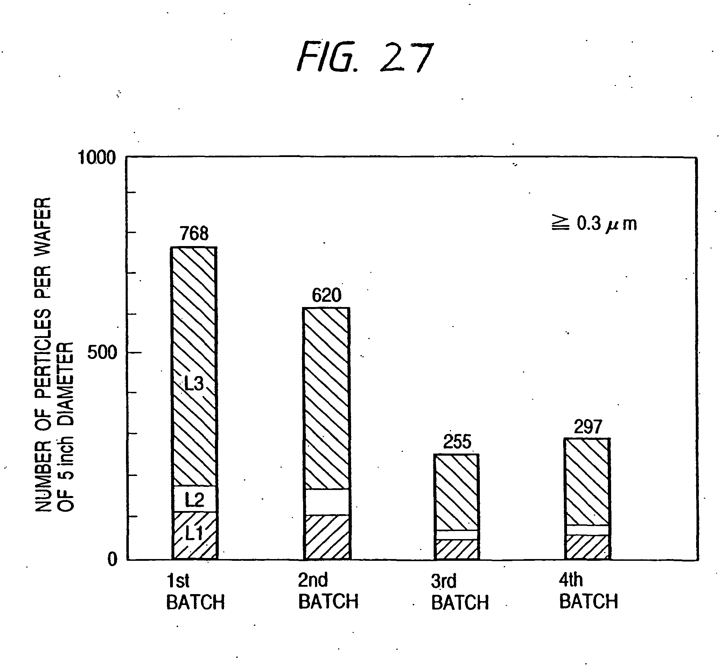

In addition, it was found by research of the present inventors that when the surface of the porous silicon substrate was rinsed with pure water after formation of the porous structure by anodization, several hundred dust particles not less than 0.3 µm, obtained from laser reflection intensity distribution, adhered to the surface in a 5-inch-diameter wafer as shown in Fig. 27. In the bar graph, classification of L1, L2, and L3 indicates rough classification of sizes of dust particles obtained from laser reflection intensities from the dust particles and the sizes increase in the order of L1 < L2 < L3.

The number of dust particles adhering upon anodization gradually decreases with increasing number of batch of anodization in the single wafer process as shown in Fig. 27, because the dust particles in liquid decrease as captured by the substrate. Such high numbers are, however, anomalous numbers when compared with those in the current semiconductor processes wherein the dust particles are removed down to several or less particles on the surface of bulk substrate after RCA-cleaned.

These dust particles adhering during anodization can be decreased to some extent by liquid circulation of the above electrolyte solution and collection of dust particles with a filter, but the decrease is not sufficient yet. Conceivable causes of adhesion of dust particles include dust particles mixed in an anodization system and in the electrolyte solution, and dust generated from workers during the process. Further, it is also conceivable that the surface of porous silicon becomes hydrophobic because of the anodization in the high-concentration hydrofluoric acid electrolyte, so that the silicon substrate tends to be electrostatically charged and thus to attract the dust particles. Therefore, prevention of adhesion of the dust particles is not easy.

As a matter of course, such dust particles became a cause to generate imperfections in the subsequent processes, particularly, such as anomalous growth or pinholes in the film-forming process, and were the hindrance in applications of porous silicon.

Japanese Laid-Open Patent Application JP-A-3014230 discloses a method for cleaning a semiconductor wafer with pure water and an ultrasonic wave at frequencies above 0.6 MHz.

### SUMMARY OF THE INVENTION

In a first aspect, the present invention provides a method of cleaning a substrate having a porous silicon layer on a surface thereof, comprising the step of:
applying a high-frequency wave with a frequency in the range of from 600 kHz to 2 MHz to the substrate in a direction parallel to the surface of the porous silicon layer while immersing the substrate in a liquid selected from pure water and water containing substantially only ozone or hydrogen peroxide, to remove dust particles adhering to the porous silicon layer.

In a second aspect, the present invention provides a method of fabricating a semiconductor substrate which comprises the steps of:
forming a porous silicon layer on a silicon substrate by anodisation,
forming an oxide film on internal wall surfaces of pores of the porous silicon layer,
growing a single crystal layer epitaxially on the porous silicon layer,
wherein the porous silicon layer is cleaned by the cleaning method described above after the step of forming the porous silicon layer and before the step of growing the single crystal layer epitaxially.

In a third aspect, the present invention provides a method of manufacturing a semiconductor device comprising steps of:
cleaning the porous silicon layer on the surface of a substrate by the cleaning method described above;
preparing the cleaned substrate for semiconductor device processing; and
processing the prepared substrate to produce a semiconductor device.

Embodiments of the present invention provide a new cleaning method capable of efficiently removing the dust particles adhering to such a porous silicon surface without using chemicals that might affect the subsequent processes and without causing collapse of the porous silicon surface.

Embodiments of the present invention also provide an efficient and economical cleaning method that can be introduced readily without a need for great change of the conventional cleaning steps and that does not have to use special chemicals.

The term "pure water" as used herein refers to water that is of a standard of purity suitable for semiconductor processing. Some degree of contamination is tolerable and will depend, for example, on the degree of integration of the semiconductor device for which the cleaned substrate is prepared. Types of contamination are listed in Table 1 below, while in Table 2 below are listed different standards of water purity that are typical of semiconductor processing in general and that would be suitable, according to requirement, for performing the present invention.

**Table 1**

| Contamination in ultrapure-water | |
|---|---|
| Pure water standards | Contamination-type |
| Particle bacteria Total silica | Particle contamination |
| Metallic ion (positive ion & negative ion) | Metallic contamination |
| TOC (Total organic carbon) | Organic contamination |
| DOC (Dissolved oxygen concentration) | Native oxide growth |

**Table 2**

| Water quality required for ultrapure water | | | | | | |
|---|---|---|---|---|---|---|
| | | 1MB | 4MB | 16MB | 64MB | 256MB |
| Resistivity | [MΩ.cm] | 17.5^{~}18 | >18.0 | >18.1 | >18.2 | >18.2 |
| Particle | >0.1µm | 10^{~}20 | <5 | | | |
| | >0.05µm | | <10 | <5 | <1 | |
| | >0.03µm | | | | <10 | <5 |
| Bacteria | | 10^{~}50 | <10 | <1 | <0.1 | <0.1 |
| Total silica | [ppb] | 5 | <1 | <0.5 | <0.1 | <0.1 |
| TOC | [ppb] | 30^{~}5,0 | 10^{~}20 | <2 | <1 | <0.2 |
| DOC | [ppb] | 30^{~}50 | 20^{~}50 | <10 | <5 | <1 |
| Metallic ion | [ppt] | 100⁻500 | <100 | <50 | <10 | <5 |

### BRIEF DESCRIPTION OF THE DRAWINGS

Fig. 1 is a graph to show the relationship between frequencies of ultrasonic cleaning and sizes of particles to be removed and to show the frequency range of the present invention;
Fig. 2 is a cross-sectional view to show an example of the porous silicon substrate;
Figs. 3A and 3B are drawings to show adhesion states of dust particles on a wafer after cleaning in the case of only immersion (Fig. 3A) and in the case of lift every five minutes (Fig. 3B);
Fig. 4 is a graph to show the relationship between concentration of residual oxygen and number of bubbles generated in the ultrasonic cleaning in pure water;
Fig. 5 is a graph to show concentrations of dissolved gas not generating bubbles in the megasonic irradiation area;
Figs. 6A and 6B are graphs to show concentration distributions of dissolved oxygen in bath;
Figs. 7A and 7B are graphs to show concentration distributions of dissolved nitrogen in bath;
Figs. 8A and 8B are graphs to show concentration distributions of dissolved oxygen upon megasonic irradiation;
Figs. 9A and 9B are graphs to show concentration distributions of dissolved nitrogen upon megasonic irradiation;
Fig. 10 is a graph to show concentration dependence of dissolved gas in pure water in the megasonic cleaning;
Fig. 11 is a conceptual drawing to explain influence of bubble in pure water upon high-frequency cleaning of a hydrophobic substrate;
Fig. 12 is a plan view to show adhering dust particles after the high-frequency cleaning where bubbles adhere to the hydrophobic substrate;
Fig. 13 is a drawing to show an example of flow of cleaning of the porous silicon substrate with pure water;
Fig. 14 is a drawing to show an example of flow of cleaning of the porous silicon substrate;
Fig. 15 is a drawing to show an example of flow of cleaning of the porous silicon substrate;
Fig. 16 is a drawing to show an example of flow of cleaning of the porous silicon substrate;
Fig. 17 is a cross-sectional view to show an example of a high-frequency ultrasonic cleaning apparatus used in the method of the present invention;
Fig. 18 is a graph to show the numbers of dust particles on the surface of porous silicon from after anodization to after low-temperature oxidation, where the high-frequency ultrasonic cleaning of the present invention is carried out;
Fig. 19 is a graph to explain the bubble removing effect in the high-frequency cleaning ;
Fig. 20 is a graph to explain the bubble removing effect in the high-frequency cleaning;
Fig. 21 is a graph to explain the bubble removing effect in the high-frequency cleaning;
Fig. 22 is a graph to explain contamination of dust particles in a carrier for cleaning;
Fig. 23 is a graph to explain contamination of dust particles in the carrier for cleaning;
Fig. 24 is a conceptual drawing to show an example of the configuration of a high-frequency ultrasonic cleaning apparatus and deaerated pure water producing apparatus;
Fig. 25 is a graph to compare removal rates of dust particle of the case where the high-frequency ultrasonic cleaning is applied to a surface of porous silicon having a hydrophobic surface, with that of a cleaning method without deaeration;
Fig. 26 is a drawing to schematically show the relationship between a porous silicon substrate and a high-frequency progressive wave;
Fig. 27 is a graph to show the numbers of dust particles on the porous silicon surface in the order of batches of anodization where cleaning is ended only with the conventional pure water rinse after anodization; and
Figs. 28A to 28F are schematic cross-section views to illustrate successive stages in the processing of a substrate in preparation for semiconductor device manufacture.

### DETAILED DESCRIPTION OF THE PREFERRED EMBODIMENTS

Embodiments of the present invention will be described and it is noted that combinations thereof also fall within the scope of the present invention.

### (Embodiment 1)

A cleaning method of porous surface according to the present invention is a method for superimposing an ultrasonic wave in the high-frequency band, the frequency of which is in the range of from 600 kHz to 2 MHz, more preferably in the range of from 800 kHz to 1.6 MHz, on pure water and exposing a surface of a porous substrate thereto.

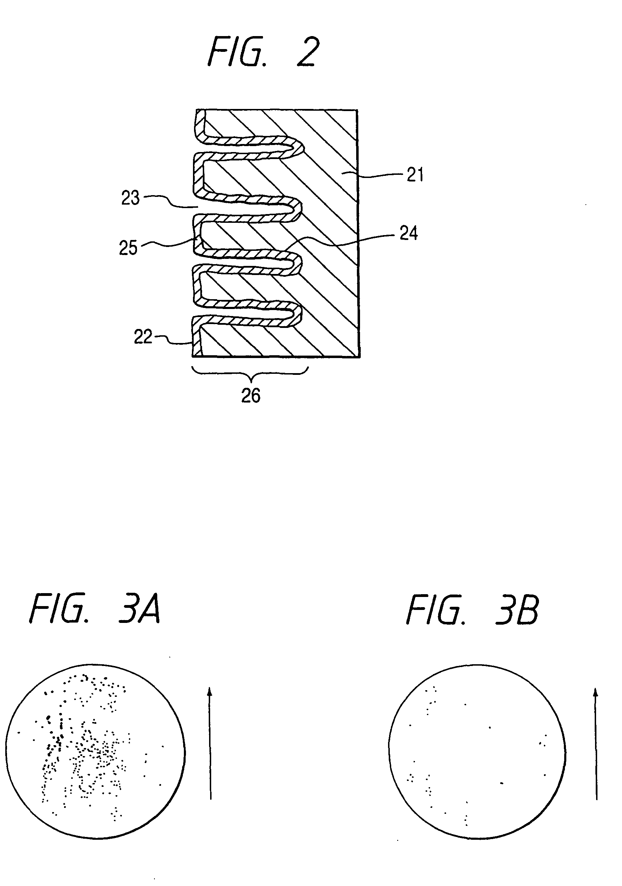

In the cleaning method of porous surface according to the present invention, the substrate is one having a porous structure in the surface, as shown in Fig. 2. The cleaning method can be applied, for example, to semiconductor materials such as silicon. Fig. 2 illustrates the structure in which a material of a different kind such as a semiconductor thin film of amorphous Si, polycrystal Si, GaAs, or the like or a metalized layer is deposited by chemical vapor deposition or the like over the internal wall surfaces of pores in the Si porous substrate. In Fig. 2, reference numeral 21 designates the substrate, 22 the surface of the substrate, 23 the pores, 24 the internal walls of the pores, and 25 the deposit film. Further, numeral 26 denotes the porous structure.

Described below is cleaning of porous silicon substrate as an example of the cleaning method of porous surface according to the present invention.

Sizes of dust particles that can be removed by ultrasonic are determined depending upon the frequency. For example, it is said that the sizes of dust particles that can be removed by high-frequency waves of 800 kHz or more are approximately 0.1 µm, the molecular acceleration given to the dust particles at this time becomes approximately a quarter million times greater than the acceleration of gravity on the surface of Earth, and the dust particles are removed by this kinetic energy. The wavelengths are as short as 0.8 mm in pure water, the waves are irregularly reflected at the surface of liquid, and some of the waves travel into the air, so that a standing wave, as seen with the ultrasonic in the low-frequency band, is little generated in the pure water. Thus, cleaning unevenness is little.

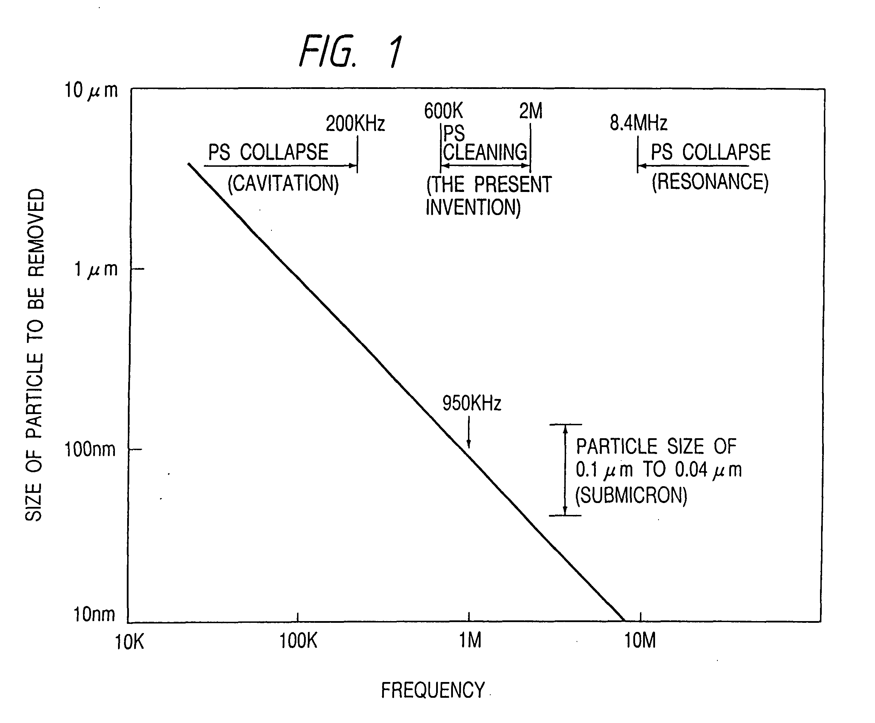

Since the ultrasonic waves have short wavelengths and high directivity, damage on the fine and fragile surface of porous silicon can be decreased by making the ultrasonic wave act in parallel to the substrate surface. In addition, the high-frequency waves are excellent in the removing effect of dust particles because of their small amplitudes and large number of scrubs on the substrate surface. Moreover, generation of ions in pure water decreases its specific resistance, so that re-adhesion of dust particles due to self-charging of substrate is little. present inventor found that for cleaning the porous substrate with pure water to which the high-frequency wave was applied, unlike the bulk substrate, a certain range existed for the high-frequency waves because of the properties of the porous substrate. This will be described with Fig. 1. In the ultrasonic cleaning of substrate, the frequency used is determined depending upon the size of dust particle. For example, from Fig. 1, it is effective to apply ultrasonic waves of frequencies of about 80 to 90 MHz in order to remove the dust particles of the particle size of 1 µm from the substrate and to apply ultrasonic waves of frequencies of about 800 to 900 kHz in order to remove the dust particles of the particle size of 0.1 µm from the substrate.

However, the experiments by the present inventor showed that in the porous Si substrate collapse of porous structure was observed under 200 kHz and collapse of porous structure was also observed similarly over 8.4 MHz, as shown in Fig. 1. This is because use of ultrasonic wave for cleaning raises problems in the case of the porous substrate, which are not experienced in the case of the bulk substrate.

As already described, the porous structure is the fine structure of several hundred angstroms or less in the case of porous silicon of p⁺-type and p⁻-type or n⁻-type and the experiments by the present inventor showed that the fragile porous surface collapsed because of cavitation when the ultrasonic waves of frequencies under 200 kHz were used.

According to the experiments by the present inventor, use of ultrasonic waves of the frequencies over 8.4 MHz caused the fine porous structure itself to resonate, similarly resulting in collapse of porous structure. The resonance frequency depends upon the porous structure. In the case of the porous structure having relatively large hole sizes and thicknesses of silicon walls ranging from several hundred nm to several ten µm like n⁺-type porous silicon, the lower limit frequency of ultrasonic wave that can be used becomes higher than that.

Accordingly, the ultrasonic cleaning of porous silicon surface is conducted with a high-frequency wave in the frequency band of from 600 kHz to 2 MHz. More preferably, the ultrasonic cleaning is conducted with a high-frequency ultrasonic wave in the frequency band as called megasonic cleaning, in the range of from 800 kHz to 1.6 MHz, which can avoid the risk of collapse of porous structure.

The bulletin of Japanese Laid-Open Patent Application No. 51-2264 discloses as to the high-frequency cleaning that cleaning of semiconductor wafer takes place with the high-frequency ultrasonic wave in the range of 200 kHz to 5 MHz, but it discloses application of the high-frequency ultrasonic wave to hydrogen peroxide and ammonia (chemicals) and discloses nothing about cleaning of porous substrate with pure water. Also, Japanese Laid-Open Patent Application No. 6-275866 discloses immersion of porous semiconductor in pure water with the ultrasonic wave being applied thereto, but the immersion in pure water is purposed to improve light emitting characteristics and is not for cleaning. It discloses nothing about the frequency of ultrasonic wave at all. Further, a method is known which discloses cleaning of bulk substrate with chemicals to which the ultrasonic wave is applied and rinsing thereof with pure water to which the high-frequency wave is applied, but discloses nothing about cleaning for removing the dust particles on the porous substrate with pure water.

As described above, the present embodiment can remove the dust particles on the surface with only the pure water and high-frequency ultrasonic wave without collapse of porous silicon.

In the case wherein dust particles newly adhering to the surface of porous silicon substrate with the porous internal walls thermally oxidized re-adhere to a hydrophobic surface after the oxide film of the outermost surface layer is etched in a diluted hydrofluoric acid reservoir, the dust particles can also be removed by the high-frequency ultrasonic cleaning in pure water.

As described previously, it was found by the research of the present inventors that even several hundred dust particles not less than 0.3 µm, obtained from the laser reflection intensity distribution, adhered to the surface of porous silicon substrate having the porous structure which was made by anodization and rinsed with pure water, in the 5-inch-diameter wafer (Fig. 27). The conceivable causes of adhesion of dust particle include those mixed in the anodization apparatus and in the electrolyte solution, and the dust generated by the workers during the process, and it is also conceivable that the porous silicon surface becomes hydrophobic because of anodization in the high-concentration hydrofluoric electrolyte solution, so that the silicon substrate becomes easy to charge electrostatically so as to adsorb the dust particles. Therefore, prevention of adhesion of dust particle is not easy.

Since the porous structure is fine and dense and has long pores, use of chemicals in chemical wet cleaning as in the conventional RCA cleaning will result in deep intrusion of the chemicals into the inside of the pores, so that it becomes difficult to eliminate the chemicals completely even by pure water rinsing for a long time, thus negatively affecting the post-processes including epitaxial growth.

This problem results from the structure of porous silicon and the experience of the present inventors is not peculiar. It can also be considered that the reason why positive cleaning of porous silicon surface does not have been conducted heretofore is based on the same problem.

The present invention is suitably applicable to cleaning of substrates having a hydrophobic surface, but it can also be applied to cleaning of substrates having a hydrophilic surface, wherein adhesion of dust particles can be prevented more certainly if generation of bubble is suppressed well.

Further, the cleaning method of porous surface according to the present invention can also be used for removing the dust particles adhering to the substrate surface having the structure wherein a material of a different kind such as a layer of semiconductor thin film of amorphous Si, polycrystal Si, GaAs, or the like or a layer of metal thin film is deposited by chemical vapor deposition or the like over the internal wall surfaces of pores of Si porous substrate, as shown in Fig. 2.

### <BUBBLE REMOVAL, NOT FALLING WITHIN THE SCOPE OF THE INVENTION CLAIMED>

A problem specific to the ultrasonic cleaning of porous silicon is generation of bubbles during cleaning.

Gas taken into the inside of porous silicon during the anodization process or during drying thereafter is discharged out of the pores as being replaced with pure water during the ultrasonic cleaning, and in the hydrophobic case, it adheres in the form of bubbles to the substrate surface. The bubbles impede propagation of ultrasonic wave and degrade the removing effect of dust particle, and they promote adsorption of dust particles, thus becoming a cause of re-adhesion of dust particles to the substrate.

Bubbles are also generated by other factors than the substrate structure. In general, bubbles are generated because of cavitation in the case of the low-frequency ultrasonic wave, while they are generated because of the dissolved gas in pure water in the case of the high-frequency ultrasonic wave. Small bubbles adhering to the porous silicon surface cannot be removed by the high-frequency cleaning without use of shock wave, but they can be removed by intermittently lifting the substrate out of the pure water during the ultrasonic cleaning.

On the other hand, though not limited to the ultrasonic cleaning, batch-type cleaning for setting plural substrates together on a carrier and immersing them in a cleaning bath has a problem that the cleaning carrier of polytetrafluoroethylene (e.g., Teflon), used for supporting the substrates during cleaning, is normally charged when simply immersed in pure water, whereby the substrate at the position of carrier end is inductively charged to adsorb the dust particles.

It is also possible to employ carrierless batch cleaning at present, but in the case of the carrier being used, a dummy substrate, used only during cleaning, is placed at the carrier end, whereby the dust particles can be prevented from adhering to the substrates at the other carrier positions. In the case wherein the porous silicon layer is formed only on one surface, the dust particles can be prevented from adhering to the porous surface, by reversely setting the porous silicon substrate at the carrier end and normally setting the other substrates.

When the ultrasonic cleaning is carried out with pure water, such a phenomenon is observed that bubbles are also generated in the pure water in the high-frequency case, especially, that bubbles adhere to the porous silicon surface having a hydrophobic surface after removal of surface oxide film.

The bubbles adhering to the surface are not easy to remove, especially, when cleaning is made with the substrate to be cleaned being set in a pure water bath on which the ultrasonic wave is superimposed. Specifically, the small bubbles adhering to the substrate are not removed even by flowing water during cleaning and the bubbles, while being still small, cannot move on the substrate surface by only buoyancy of themselves, so as to be fixed thereon. The bubbles impede propagation of ultrasonic wave so as to degrade the cleaning effect, and also draw fine dust particles in the pure water to the gas-liquid interface, in turn contaminating the substrate surface to be cleaned, by the dust particles.

Thus, as mentioned above, a method for avoiding such problem of contamination of the cleaned substrate due to generation of such bubbles is the method of regularly lifting the cleaned substrate out of the pure water bath during cleaning to thereby remove the bubbles.

Figs. 3A and 3B show states of bubbles remaining on the wafer. Fig. 3A illustrates positions and the number of dust particles not less than 0.2 µm on a 5-inch-diameter bulk wafer surface where only immersion was conducted but removal of bubbles was not carried out in the ultrasonic cleaning in pure water, and Fig. 3B similarly illustrates positions and the number of dust particles where removal of bubbles was carried out by lifting the wafer every five minutes. The number of dust particles is 450 in Fig. 3A while it is 35 in Fig. 3B. As apparent from comparison between Fig. 3A and Fig. 3B, the dust particles aggregate densely along the bubble rise direction (indicated by the arrow in each drawing) when the removal of bubble is not carried out, whereas the removal of bubble relieves this tendency.

When porous silicon having the hydrophobic surface is cleaned by this cleaning method for 20 minutes by superimposing the ultrasonic wave of 950 kHz on an ordinary-temperature over-flow pure water bath and lifting the substrate every five minutes out of the pure water bath for removal of bubble, approximately 30 % to 40 % of dust particles, which were unable to clean before, can be removed from the surface of porous substrate. With further repetition of the same cleaning for 20 minutes more, 60 % to 80 % of the dust particles before cleaning can be removed.

Such fixing of bubbles does not occur on a hydrophilic porous silicon surface having an oxide film on the surface, and the bubbles quickly rise to be eliminated, so that contamination of the substrate due to the dust particles can be avoided. Thus, almost 90 % of dust particles were able to be removed by the high-frequency ultrasonic cleaning without regular lift of substrate.

There are, however, some cases wherein further removal of dust particles is desired depending upon purposes of use. If in the above cleaning method the cleaning period of time were prolonged in the ultrasonic pure water in order to further remove the dust particles, a native oxide film could be formed because of the pure water, in addition to the problem of reduction of work efficiency. This cleaning effect is not improved by raising the temperature of pure water.

The method for regularly lifting the substrate out of the pure water bath during cleaning would be extremely cumbersome, for example, if the cleaning should rely on labor of worker. Further, it is not easy to perfectly avoid generation of bubbles and adhesion thereof to the substrate during cleaning even by carrying out the bubble removing operation based on the regular lift, and a further improvement is desired in terms of reproducibility and stability of cleaning.

An alternative to the method of regularly lifting the substrate out of the pure water bath is a method for cleaning the substrate with pure water from which dissolved gas is deaerated, thereby preventing contamination of the substrate due to the dust particles in the pure water, caused by generation of bubbles and adhesion thereof to the substrate during the ultrasonic cleaning.

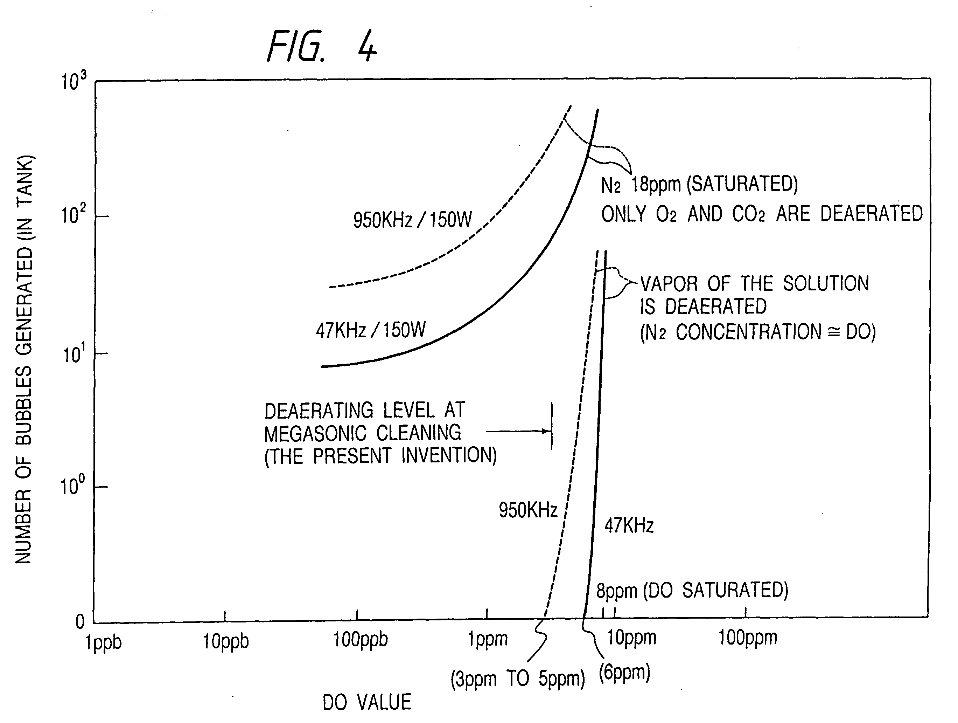

In cleaning of semiconductor substrate, it is known that O₂ and CO₂ are deaerated for antioxidation on the semiconductor substrate. However, N₂, reducing gas, was not considered specifically to be a problem, but, on the contrary, the cleaning water was used with N₂ taken in up to the saturation concentration thereof (17.8 ppm at 25°C and 6.7 ppm in warm pure water of 80°C). The number of bubbles generated with ultrasonic waves of frequencies of 47 kHz and 950 kHz and with changing concentration of residual oxygen for the pure water of 25°C containing N₂ is shown in Fig. 4. The number of bubbles generated in the case of the frequency of 950 kHz was greater than that in the case of the frequency of 47 kHz. At 5 ppm, 100 or more bubbles were generated in either case and these bubbles were found to be a cause of adhesion of dust particles. It was also found that it was not easy to avoid the generation of bubble even if the pure water was heated to 80°C.

An investigation was made of the number of bubbles generated by the ultrasonic waves of the frequencies of 47 kHz and 950 kHz with changing concentration of residual oxygen similarly and with also deaerating N₂. It was found that substantially no bubbles were generated around 6 ppm at 47 kHz or around 3 to 5 ppm at 950 kHz, so that deaeration (including N₂) was able to suppress the generation of bubble independently of the frequencies of ultrasonic wave so as to remove the dust particles from the substrate.

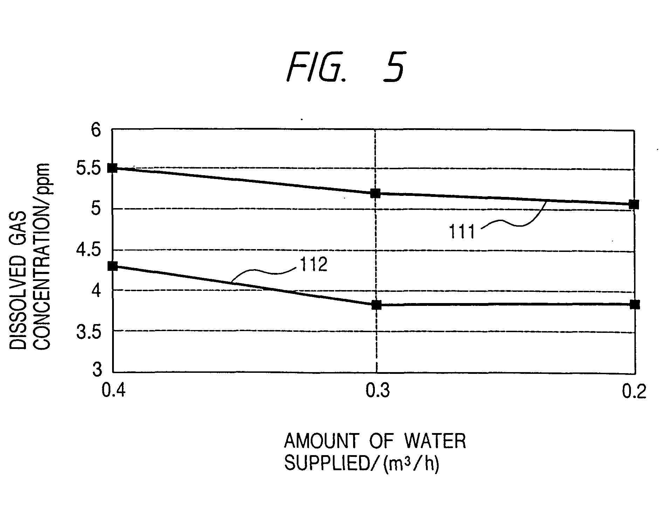

Measurements were made of concentrations of dissolved gas in pure water in a square-shaped over-flow bath in a water supply state, using a dissolved oxygen/dissolved nitrogen sensor available from Orbisphere Laboratories, Inc. From the results of the measurements, when water was supplied from the bottom portion of the over-flow bath under irradiation of megasonic wave of power 600 W and frequency 950 kHz and, though depending upon the rate of water supplied as shown in Fig. 5, when the rate of water supplied was in the range of 0.2 m³/hr to 0.4 m³/hr optimum for the over-flow operation, no bubbles were found to be generated in the entire area of the bath if the concentration of dissolved nitrogen in the pure water as the supplied water was under the range of 5 ppm to 5.5 ppm and if the concentration of dissolved oxygen was under the range of 3.83 ppm to 4.3 ppm. In Fig. 5 curve 111 represents the concentration of dissolved nitrogen and curve 112 the concentration of dissolved oxygen.

In the normal semiconductor processes pure water with nitrogen gas dissolved after primary deaeration is used at a use point.

It was also found that using pure water containing dissolved oxygen in the concentration of 7.38 ppb and dissolved nitrogen in the concentration of 14.57 ppm close to the saturation concentration thereof before, bubbles were generated by megasonic irradiation if only the dissolved oxygen was deaerated and if the dissolved nitrogen existed 5 ppm or more.

From this, it is necessary to control concentrations of gases dissolved in high concentrations among the dissolved gases in the pure water in order to suppress the generation of bubble when the megasonic wave is applied to the pure water, and it is thus necessary at least to control concentrations of respective gases of nitrogen, oxygen, and CO₂, which are main component gases of air.

### (Dalton's law of partial pressure)

The reason why the main component gases of air are noted particularly is that the bath used for cleaning is normally of such structure that the surface of liquid is open to the atmosphere and that even with the over-flow operation the gases composing the atmosphere (air) are re-dissolved into the liquid from the liquid surface and amounts thereof are not negligible.

The re-dissolution of air in contact with the liquid surface is outstanding in the case of a water reservoir. Even if deaerated water is supplied from the reservoir bottom to be stored, concentrations of dissolved gases increase toward the liquid surface with respect to those at the reservoir bottom, thus making distributions of concentrations of dissolved gases in the reservoir. With a lapse of time the distributions in the reservoir are made even to high concentrations, which makes control of concentration of dissolved gas difficult. (Henry's law)

On the other hand, in the case of the over-flow bath, the pure water containing controlled concentrations of dissolved gases is always supplied by supplying deaerated water from the bath bottom portion and flows over to be drained out of the bath. This is considered to be a reason of capability of controlling the concentration of dissolved gas constant in the bath.

In practice, however, there appears such a phenomenon, depending upon the rate of water supplied, that the deaerated water reaching the liquid surface comes to contact the atmosphere so as to re-dissolve the gases and part thereof is not drained and again circulates in the bath, thereby increasing the concentrations of dissolved gases in the bath.

In order to solve this problem, important points are optimum design of structure of bath and optimum setting of the rate of water supplied.

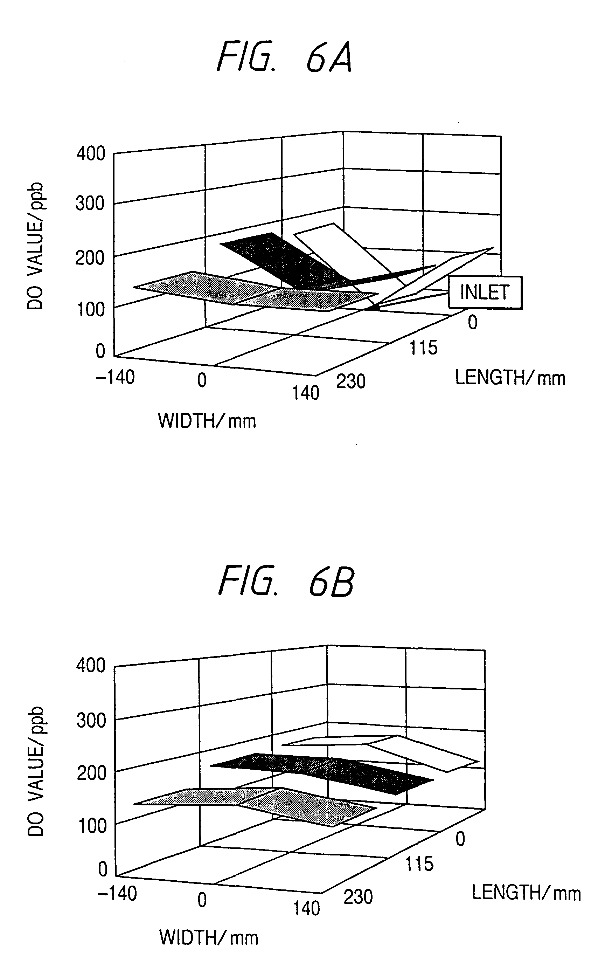

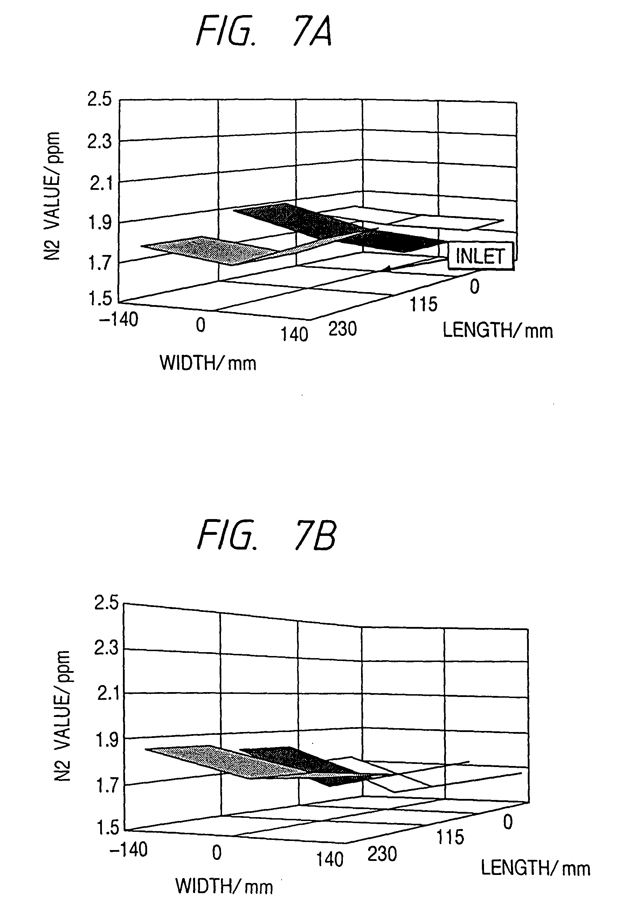

As an example, distributions of dissolved oxygen concentration (DO value) and dissolved nitrogen concentration (N2 value) at the depth 25 cm (at the bath bottom) and at the depth 12.5 cm (at the middle of bath) in the square-shaped over-flow bath of the size of the width 28 cm, the length 23 cm, and the depth 25 cm are illustrated in Fig. 6A, Fig. 6B, Fig. 7A, and Fig. 7B. Here, Fig. 6A shows the concentration distribution of dissolved oxygen in the bath at the depth of 25 cm (at the bottom of bath) and Fig. 6B shows the concentration distribution of dissolved oxygen in the bath at the depth of 12.5 cm (at the middle of the bath). Fig. 7A shows the concentration distribution of dissolved nitrogen in the bath at the depth of 12.5 cm and Fig. 7B shows the concentration distribution of dissolved nitrogen in the bath at the depth of 25 cm.

While the pure water of the oxygen concentration 1.88 ppb and the nitrogen concentration 1.542 ppm after secondary deaeration at the use point was being supplied at the water supply rate 0.3 m³/hr from the bath bottom portion (at the depth of 25 cm) to flow over, the concentration of dissolved oxygen and the concentration of dissolved nitrogen were measured at each position in the bath.

The arrow in the drawing indicates a direction of water supply in the bath bottom portion.

Regardless of the gas species, the concentration of dissolved gas is lowest at the water supply port and the concentration increases with increasing distance from the water supply port along flow of the pure water in the bath bottom portion. At the depth 12.5 cm the concentrations were higher than in the bath bottom portion, but the concentration distributions were almost uniform, showing the oxygen concentration of about 150 ppb and the nitrogen concentration of about 1.8 ppm.

Here, turbulent flow occurs in the flow of water, depending upon the position and direction of the water supply port and the water supply rate, which increases the concentrations in the bath. Thus, for example, when the concentrations in the bath are controlled by the concentrations of dissolved gases in the secondarily deaerated water, optimum design to keep the concentrations in the bath low as described above is necessary.

Further, the concentrations of dissolved gases in the deaerated water in the over-flow bath under megasonic irradiation slightly increase with time of irradiation.

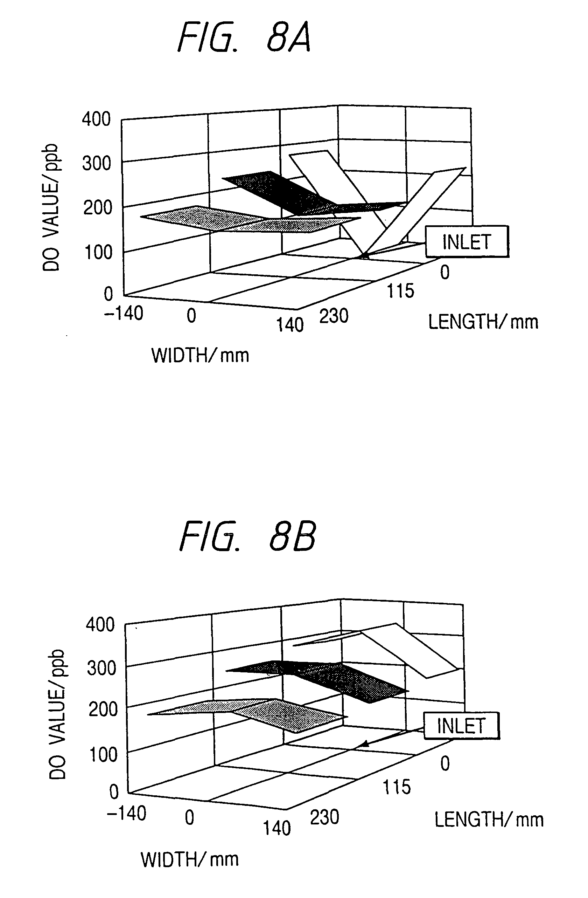

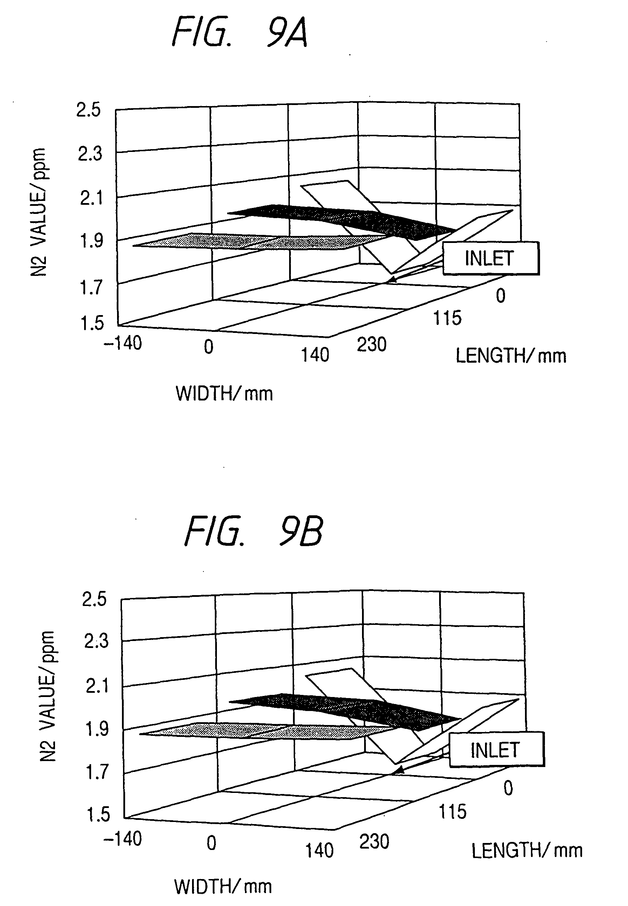

Concentration distributions of dissolved oxygen in the over-flow bath under megasonic irradiation of power 600 W and for 10 minutes from the bath bottom portion are shown in Fig. 8A and Fig. 8B and concentration distributions of dissolved nitrogen are shown in Fig. 9A and Fig. 9B. Here, Fig. 8A shows the concentration distribution of dissolved oxygen at the depth of 25 cm (at the bath bottom) under megasonic irradiation and Fig. 8B shows the concentration distribution of dissolved oxygen at the depth of 12.5 cm (at the middle of bath) under megasonic irradiation. Fig. 9A shows the concentration distribution of dissolved nitrogen at the depth of 25 cm under megasonic irradiation and Fig. 9B shows the concentration distribution of dissolved nitrogen at the depth of 12.5 cm under megasonic irradiation. Although changes are small, it is necessary to set the concentrations of dissolved gases in the deaerated water supplied, also taking such concentration changes under the conditions of practical use into consideration, in order to accurately control the concentrations of dissolved gases in the bath.

Namely, the cleaning method of surface may be arranged in such a way that cleaning for removing the dust particles adhering to the surface of substrate takes place with the pure water from which the dissolved gas is deaerated until the concentration of dissolved gas becomes 5 ppm or less and on which the ultrasonic wave is superimposed. "The concentration of dissolved gas is 5 ppm or less" means that the concentration of any dissolved gas, regardless of kinds of dissolved gases, is 5 ppm or less, but in general, it is sufficient that the concentrations of dissolved gases including oxygen, nitrogen, and CO₂ as the main components of air are 5 ppm or less.

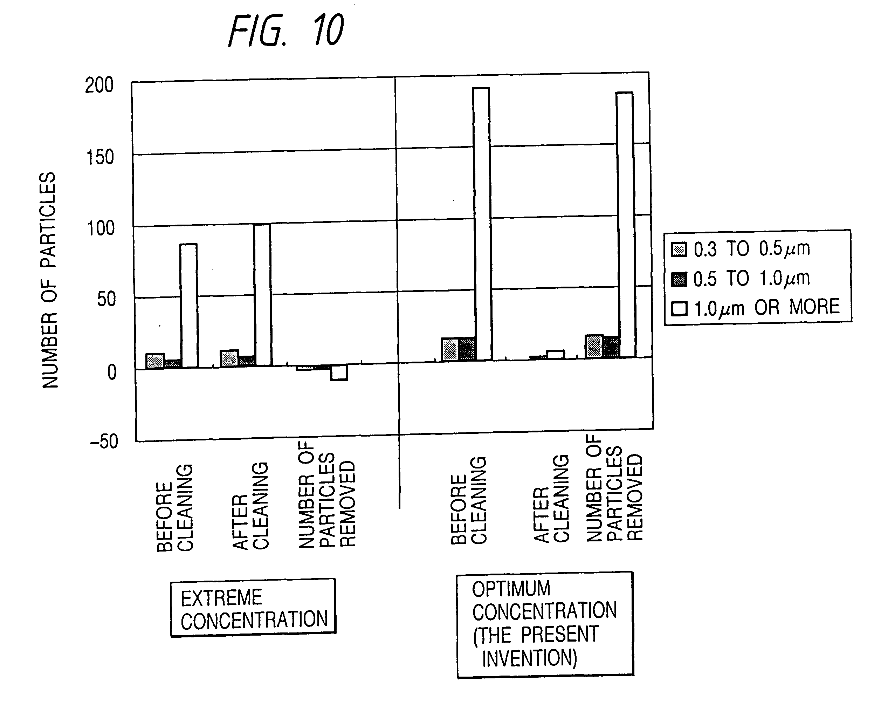

However, megasonic cleaning experiments as to concentration dependence of dissolved gas in the pure water in the megasonic cleaning showed clearly, as shown in Fig. 10, that the cleaning effect by the megasonic irradiation was excellent with use of deaerated water in the controlled concentrations of dissolved gases below the boundaries not generating bubbles (the concentration of dissolved nitrogen not more than 5 ppm and the concentration of dissolved oxygen not more than 3.8 ppm), but no cleaning effect by the megasonic irradiation was achieved at all with use of deaerated water by secondary deaeration to the limit to decrease the dissolved gases (up to the concentration of dissolved oxygen of 150 ppb and the concentration of dissolved nitrogen of 1.8 ppm as concentrations in the bath), though no bubbles were generated.

The reason of this is not apparent yet, but the principle of megasonic cleaning is not only from the "sound wave scrub cleaning" as mentioned heretofore, but the above result suggests such a possibility that the megasonic cleaning is cleaning based on the synergistic effect with the "liquid resonance cleaning" by cavitation as in the low-frequency ultrasonic cleaning. Generation of bubble by the megasonic irradiation under existence of the high concentrations of dissolved gases is also evidence of the liquid resonance phenomenon.

It is, however, known that in the megasonic cleaning the sound pressure generated by cavitation impact is very low, and the cavitation phenomenon will be weak, even if the liquid resonance is present.

It is said that the radius of cavitation decreases with increasing frequency in ultrasonic vibration. Supposing that the sound pressure is generated by cavitation, denser generation of high-frequency resonance than of low frequency does not always contradict with the weak cavitation impact.

The small radius of cavitation and the high density thereof will result in excellent performance for removing particles of smaller particle sizes.

The cavitation phenomenon splits water molecules by ultrasonic vibration, irrespective of the frequency, whereby a kind of small space in a vacuum state is made in the pure water. It is thus conceivable that this space expands and quickly contracts finally, thereby generating the sound pressure.

It can be considered that generation of bubble occurs in such a way that the gas dissolved in water is deaerated into this space in the vacuum state and that when the space contracting speed is greater than the speed of re-dissolution of the gas in the space into the pure water and when the density of gas is high, the gas, having nowhere to go, remains in the form of bubbles.

The bubbles adhering to a hydrophobic substrate, which are not removed by over flow, disappear several minutes (two to three minutes) after supply of the pure water deaerated to the limit with stopping the ultrasonic irradiation.

From this, the gas deaerated into the fine vacuum space by cavitation is considered to re-dissolve in the pure water.

Control of generation of bubble under ultrasonic irradiation by controlling the concentration of dissolved gas is nothing but decreasing the amount of gas remaining as bubbles by lowering the density of gas deaerated and discharged into the fine vacuum space.

It is, however, not clear why no megasonic cleaning effect appears in use of the pure water deaerated to the limit, but adhesion of particle increases on the contrary.

It is assumed that there is contribution of dissolved gas to the cavitation phenomenon, i.e., that the fine space is maintained by repetitive processes of vacuum, release (deaeration) of dissolved gas into the space, and re-dissolution of gas into the pure water upon contraction, or that it results from the electrochemical action due to generation of ion species from the dissolved gas in the pure water and the change of potential of the substrate due to the megasonic irradiation, as mentioned heretofore.

The following prior art is related to deaeration. For achieving recent VLSI and ULSI of sub-micron or deep-micron, it is demanded to suppress formation of native oxide film, and Morita et al. reported that dissolved oxygen in the pure water used for cleaning was a very important factor for formation of native oxide film in pure water and that removal of dissolved oxygen to the limit was the minimum condition for suppressing the formation of native oxide film (Ultra Clean Technology, Vol. 1, No. 1, pp. 22-28, 1989).

Presently known methods for deaerating dissolved oxygen down to the dissolved oxygen concentration 5 ppb or less in the water, close to the limit concentration region, include film deaeration as a physical deaeration method and a method of combination of catalyst with a reducing method as a chemical deaeration method. Specifically, the film deaeration method is popularly used in recent years, because it little contaminates the pure water and because it can remove the dissolved gases other than oxygen.

However, these technologies are not those associated with removal of dust particles on the substrate, and it is thus needless to mention that they suggest nothing about cleaning of porous substrate.

The removal of bubbles will be described further. In the ultrasonic cleaning bubbles are generated during cleaning. Sources to generate bubbles are the gas captured in the inside after drying of porous silicon and discharged as replaced by the pure water out of the holes during the ultrasonic cleaning, and the dissolved gas such as oxygen and nitrogen dissolved in the pure water used for cleaning, which turn to bubbles because of the cavitation by ultrasonic.

The bubbles adhering to the surface of hydrophobic substrate impede propagation of ultrasonic wave so as to lower the removing effect of dust particle, and in addition, they promote adsorption of dust particle to the substrate, thereby becoming the cause of contamination of the surface due to the dust particles and degradation of the cleaning effect.

As described previously, the bubbles adhering to the porous silicon surface can be removed by intermittently lifting the substrate out of the pure water during the ultrasonic cleaning. However, if one of the causes of generation of bubble is the dissolved gas in the pure water used for cleaning, there will be naturally a limit of the cleaning effect even with such technique.

Almost 90 % of dust particles are removed by the high-frequency ultrasonic cleaning with pure water of the surface of porous silicon substrate made hydrophilic by oxidation, and thus, the degree of impedance against cleaning due to deaeration of bubbles captured in the inside of porous structure can be considered to be minute as compared with the problem caused by generation of bubbles from the pure water.

In the case of the porous structure having the hydrophobic surface, an amount of bubbles deaerated from the inside of porous structure and fixed to the surface is considered to be far smaller than an amount of bubbles generated from the pure water.

In addition, since the bubbles themselves are not easy to deaerate in the case of the porous internal walls being hydrophobic, they are unlikely to be an element to impede the cleaning. Accordingly, when one of the causes to generate bubbles is the dissolved gas in the pure water used for cleaning, it is most effective to use the pure water from which the dissolved gas in the pure water is deaerated for further enhancing the cleaning effect of substrate.

When the air of 25°C and 1 atm is in contact with water, the gas dissolved in water is considered to be such that the concentration of dissolved oxygen in water is 8.26 ppm and the concentration of dissolved nitrogen is 13.9 ppm.

In general, the pure water used in the semiconductor fields is supplied under nitrogen purge of a pure water bath in a polishing system in order to maintain the purity of the pure water.

It is thus considered that nitrogen is dissolved almost in a saturated state in the pure water. For example, the saturation dissolution concentration of nitrogen gas (purity: 99.999 %) under 25°C and 1 atm into the pure water becomes even 17.8 ppm. In addition, the dissolution concentration depends upon the temperature of water, and the concentration of nitrogen that can be dissolved decreases with increasing temperature of water.

When this pure water is heated at 80°C, the concentration of dissolvable nitrogen becomes 6.7 ppm. Excessive nitrogen corresponding to the difference of concentration of 11.1 ppm results in generating bubbles.

Generation of bubble due to heating can be prevented by removing the dissolved gas in the pure water down to below the saturation concentration using a film deaeration apparatus, but bubbles can be generated even in concentrations below this saturation concentration when the high-frequency ultrasonic wave is superimposed. It is thus more desirable to remove the dissolved gas to the optimum concentration region.

Fortunately, by connecting to the outlet of pure water producing apparatus a film deaeration apparatus in which a hydrophobic film is disposed at a portion corresponding to the interface and in which the primary-side pure water is deaerated by decreasing the partial pressure on the secondary side by reduction of pressure with a vacuum pump, and by using the system, it is possible even now to obtain the pure water having the concentration of dissolved oxygen in the limit concentration region of 5 ppb or less for the pure water of 60°C or less.

Use of the pure water from which the dissolved gas in pure water is removed in this way suppresses the generation of bubbles due to the high-frequency ultrasonic wave even with heating of pure water and suppresses the fixing of bubbles to the hydrophobic substrate surface.

Prevention of generation of bubbles enables further removal of dust particle in the same cleaning time as before without performing the lifting operation of hydrophobic porous silicon substrate, and this effect is not degraded by heating of pure water during cleaning.

As described above, cleaning with a high-frequency ultrasonic wave in pure water from which the dissolved gas was removed, enables removal of dust particles on the surface at high efficiency and in a short time

However, it has been observed in the above-stated cleaning method that bubbles are also generated from the pure water in the case of application of high-frequency ultrasonic wave and that the bubbles adhere, particularly, to the hydrophobic substrate surface.

The bubbles impede propagation of ultrasonic wave so as to degrade the cleaning effect and draw fine dust particles in the pure water to the gas-liquid interface so as to contaminate the substrate surface with the dust particles. Adhesion of bubbles to the substrate surface is little observed on the hydrophilic surface, whereas adhesion and fixing of bubble occurs on the hydrophobic surface. It is thus not easy to perfectly prevent adhesion of dust particles to the hydrophobic surface due to the bubbles, by the flowing water and ultrasonic wave in the cleaning bath.

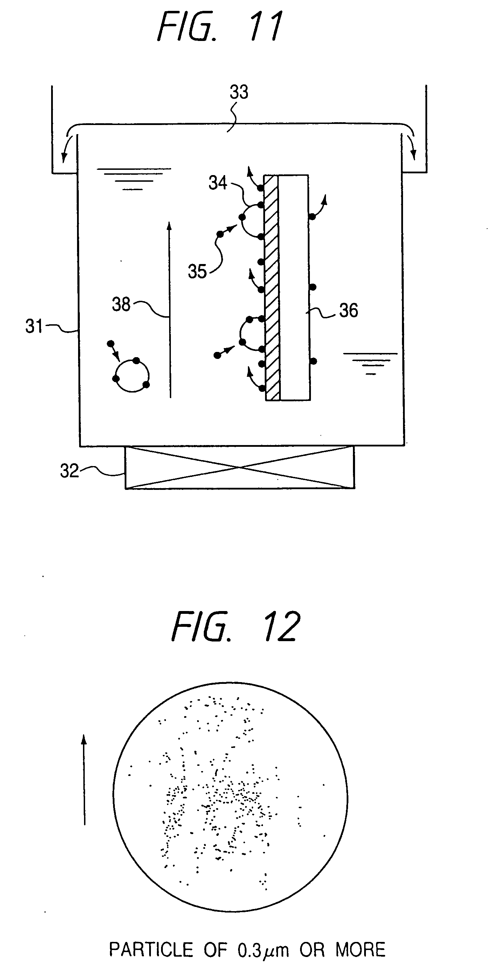

This will be described in further detail. Fig. 11 shows adhering states of bubbles and moving states of dust particles on the hydrophobic substrate, where the high-frequency wave is superimposed on the pure water. In the figure reference numeral 31 designates a quartz high-frequency cleaning bath, 32 a high-frequency vibrating plate, 33 pure water not subjected to deaeration of dissolved gas, 34 bubbles, 35 dust particles, 36 a porous silicon substrate having a hydrophobic surface, and 38 a high-frequency progressive wave.

The low-frequency ultrasonic cleaning normally experiences generation of bubbles due to the cavitation in the pure water, whereas the high-frequency cleaning involves reduced cavitation, but experiences deaeration of dissolved gas due to high-frequency vibration in the pure water, thereby generating bubbles. The source of these bubbles is the dissolved gas such as oxygen and nitrogen dissolved in the pure water.

The gas-liquid interface of bubble has higher energy than in the liquid and thus collects to capture fine dust particles in the pure water. In addition, the hydrophobic substrate surface is stable in terms of energy with respect to the gas, and the bubbles are thus likely to adhere thereto. Since the pure water cannot intrude into between the bubble and the substrate surface, it is difficult to remove the bubbles from the substrate. For example, while the bubbles are as small as about 1 mm in diameter, they cannot even move on the substrate surface only by buoyancy of themselves.

When the high-frequency ultrasonic wave is applied to the substrate surface, the surface receives kinetic energy in the direction of the progressive wave, but the energy is insufficient to move the bubbles, so that the bubbles are fixed to the substrate surface.

Adhesion of the bubbles to the substrate surface promotes collection of fine dust particles in the pure water, and further adhesion of bubbles thereto causes the bubbles to move on the substrate surface by buoyancy of themselves, which makes the collected dust particles adhere to the substrate surface along the moving path thereof, thereby contaminating the substrate.

In addition, the bubbles adhering to the substrate surface impede propagation of high-frequency wave to the substrate surface per se, thereby degrading the cleaning effect. Namely, generation of bubbles in the high-frequency cleaning of substrate having the hydrophobic surface will result in degrading the cleaning effect, because the high-frequency cleaning of dust particle on the substrate surface advances at the same time as the contamination of substrate by the dust particles in the pure water due to the adhesion of bubbles.

As described previously, if bubbles are generated during high-frequency cleaning with pure water, the bubbles will adhere to the surface of the hydrophobic substrate so as to impede the cleaning action and to be a cause to collect the dust particles in the pure water onto the substrate surface, thus contaminating the surface. Fig. 12 shows the result of inspection where a state of adhesion of dust particles to the substrate surface was checked with a dust particle inspection system after the hydrophobic, porous silicon substrate was subjected to the high-frequency cleaning in pure water without performing the lift of substrate and the deaeration process of pure water. In Fig. 12 the arrow represents the rise direction of bubble. The high-frequency progressive wave is also applied so as to travel in the same direction. Adhesion contamination of dust particle is recognized along the rise path of bubbles adhering to the substrate surface.

For this reason, it is desired to perform the regular lift operation of substrate during the high-frequency cleaning when the pure water without deaeration is used, or to perform the high-frequency cleaning with pure water from which the dissolved gas in the pure water is deaerated.

Deaeration of dissolved gas in the pure water can compensate for the gas concentrations at the exit of deaerating apparatus, but in the case of reserving waster in a pure water high-frequency cleaning bath, re-dissolution of oxygen and nitrogen occurs from the atmosphere within a short time even under flow of water. Thus, some measure becomes necessary for the structure of cleaning bath, gas seal, and the like in order to compensate for the concentrations of dissolved gas in the pure water in the cleaning bath.

### (Embodiment 2)

In Embodiment 2, the porous silicon surface is subjected to the hydrophilic process and then to ultrasonic cleaning. The ultrasonic cleaning of porous silicon surface is carried out in the high frequency band of from 600 kHz to 2 MHz. More preferably, cleaning is carried out using the high-frequency ultrasonic wave in the frequency band as called megasonic cleaning ranging from 800 kHz to 1.6 MHz, thereby avoiding the risk of collapse of porous structure.

Now described is the ultrasonic cleaning of Embodiment 2 for the porous silicon surface processed by the hydrophilic process.

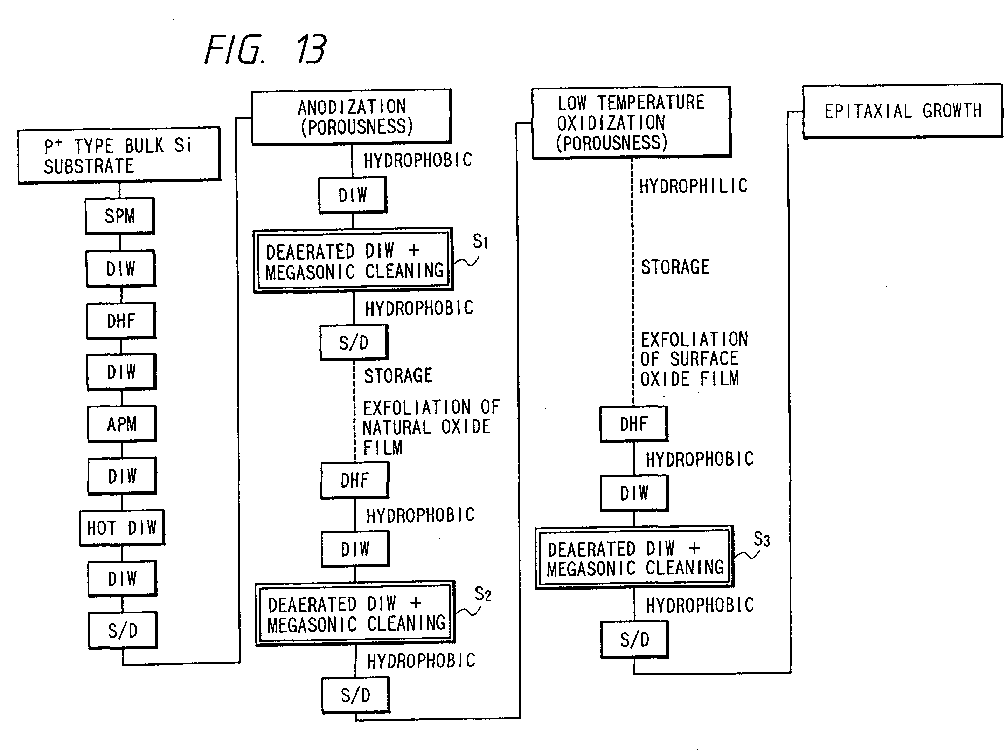

Fig. 13 shows an example of flowchart of the fabrication process up to epitaxial growth on porous silicon and the cleaning method. In the drawing, SPM stands for H₂SO₄/H₂O₂ mixture, DIW for pure water, DHF for dilute HF solution, APM for NH₄OH/H₂O₂/H₂O mixture, and S/D for spin drying.

Cleaning of bulk silicon substrate before anodization is cleaning with chemicals, as before, but the apertures of holes of the porous structure are exposed in the substrate surface from after formation of porous silicon by anodization to epitaxial growth.

As apparent from the flowchart, the chemicals normally used for cleaning of bulk silicon substrate, such as SPM, APM, or HPM (HCl/H₂O₂/H₂O mixture), cannot be used while the apertures of holes of porous silicon are exposed in the surface. Only DHF and pure water can be used in that period.

As described previously, many dust particles adhere to the surface in the forming process of porous silicon by anodization.

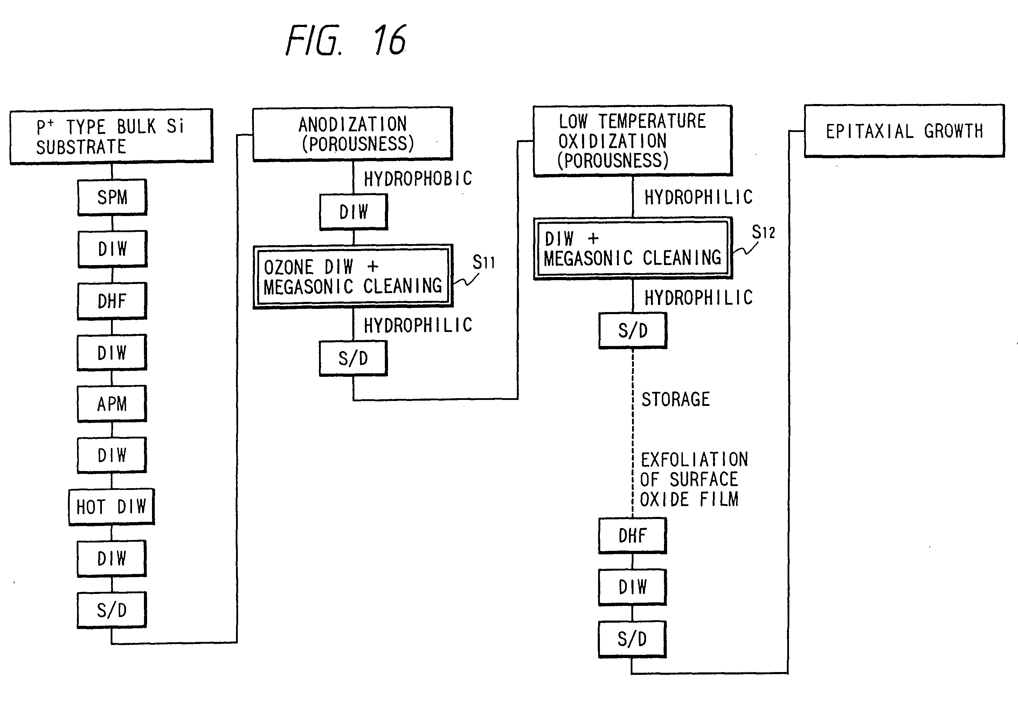

In the case wherein a single-crystal silicon film is epitaxially grown on a surface of porous silicon substrate, an oxide film is formed over the internal wall surfaces of porous structure (by forming a native oxide film or by a low-temperature oxidation step of Fig. 16) in order to decrease the structural change of the porous structure in the heating process at high temperatures. Further, the epitaxial growth is carried out after at least the oxide film over the porous surface (of silicon substrate) is selectively removed immediately before the growth. In this case, the oxide film is left on the internal wall surfaces of holes of porous structure. Specifically, the oxide film on the porous silicon surface is removed by immersion in DHF for a short time, the substrate is drawn up out of the DHF bath before the DHF solution deeply intrudes into the holes of porous structure, and the substrate is rinsed with pure water.

For example, before the epitaxially grown layer is formed on the porous silicon by the thermal CVD process at the temperature of about 1000°C, an oxide film is formed by low-temperature oxidation of the internal walls of holes of porous silicon at 400°C and for one hour.

However, adhesion of new dust particles numbering 100 or so is observed on the surface in the substrate after the thermal oxidation step. Such dust particles are considered to be generated by abrasion due to scrub between a quartz boat with substrates being arranged thereon and a quartz furnace tube.

Since the oxide film on the porous silicon surface is removed by etching with dilute HF solution immediately before the epitaxial growth, these dust particles are liable to be considered as lifted off to be removed from the surface at the same time as the removal of oxide film.

In practice, however, the number of dust particles after the etching with dilute HF solution little changes or even increases on the contrary. This is because the porous surface becomes hydrophobic after removal of the oxide film and the dust particles floating in the etching bath are adsorbed to the substrate by flowing water charging of the substrate upon lift of substrate, thereby again adhering to the substrate.

Incidentally, since anodization uses the high-concentration HF electrolyte solution, the porous silicon surface becomes hydrophobic, as shown in Fig. 13, after the anodization, as after the removal of oxide film with DHF after the low-temperature oxidation.

The cleaning method of porous surface according to Embodiment 2 of the present invention is the method for oxidizing the porous surface into a hydrophilic surface so as to facilitate occurrence of the cleaning effect in the high-frequency cleaning with pure water and for removing the dust particles of substrate surface from the hydrophilic surface by the pure-water high-frequency cleaning. When a single-crystal silicon film is epitaxially grown on the porous silicon surface after the etching removal with dilute HF solution, immediately before the epitaxially growth, of the clean surface oxide film of porous silicon substrate from which such dust particles have been removed, the single-crystal silicon film with good quality can be formed.

The cleaning method of porous surface according to the present invention can also be applied for removing the dust particles adhering to the substrate surface having such structure that a film of a material of a different kind than the Si porous substrate, such as a semiconductor thin film of amorphous Si, polycrystal Si, GaAs, or the like or a layer of metal thin film is deposited by chemical vapor deposition or the like on the internal wall surfaces of pores of Si porous substrate, as shown in Fig. 2.

In the case wherein the layer of the semiconductor thin film or the metal thin film is formed directly on the internal wall surfaces of pores of the porous substrate as shown in Fig. 2, the layer of semiconductor thin film or metal thin film may be formed after the substrate surface oxide film and the internal wall oxide film formed by the hydrophilic process are removed.

As described previously, porous silicon immediately after anodization has the hydrophobic surface, because the conc HF mixture solution is used as an electrolyte solution. When an oxide film is formed on this surface, this surface becomes hydrophilic. If the surface is hydrophilic and even if bubbles are generated in high-frequency cleaning with non-deaerated pure water, the bubbles will not adhere to the substrate surface, whereby the high-frequency cleaning with pure water can demonstrate the cleaning effect with high removing rate.

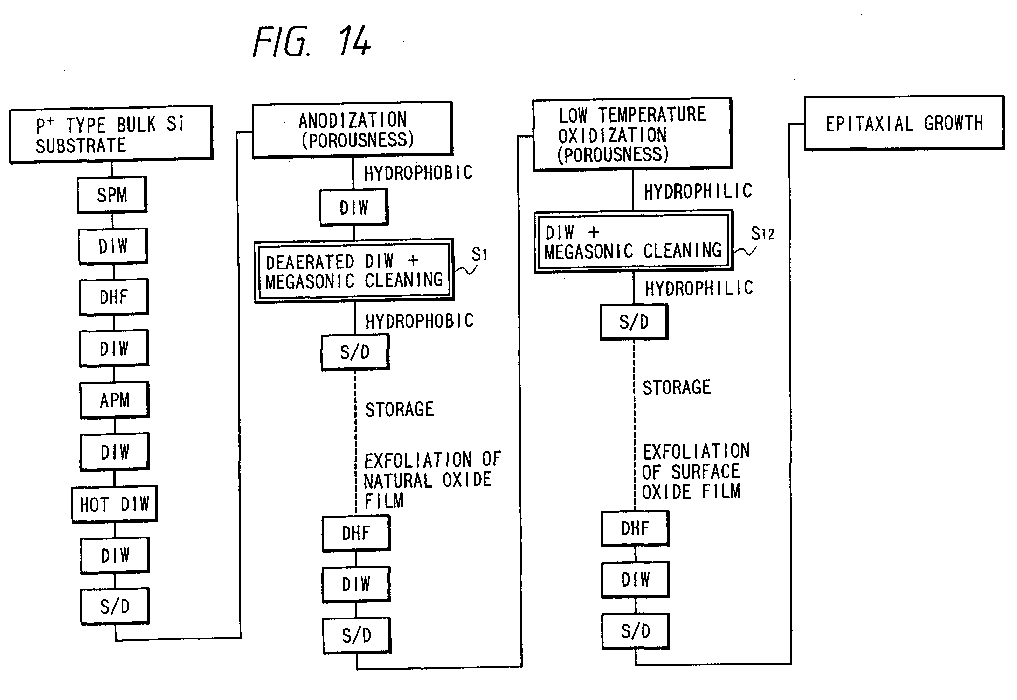

Specifically, when the substrate is made hydrophilic by low-temperature oxidation before the cleaning step S₁₂ as shown in Fig. 14, even with generation of bubbles on the hydrophilic substrate surface similarly, the substrate surface is stable and shows a good wetting property to pure water and, therefore, the substrate surface is always covered with pure water, thus preventing the bubbles from adhering thereto.

Accordingly, the dust particles collected by the bubbles are prevented from transferring to the substrate and do not impede propagation of high-frequency wave, thus demonstrating the cleaning effect sufficiently.

As described, the pure-water high-frequency cleaning of hydrophilic substrate does not need to perform the countermeasure of the regular lift operation of substrate, the deaeration process of pure water, or the like, and the high cleaning action can be expected by keeping the substrate immersed in the pure-water high-frequency bath during cleaning even with generation of bubbles as in the case of the deaerated pure water.

It is well known that the surface of silicon oxide film is hydrophilic. However, the present inventor discovered that the low-temperature-oxidized surface of porous silicon is also hydrophilic similarly.

As already described with Fig. 13, this low-temperature oxidation process is carried out as a process before epitaxial growth on porous silicon in order to decrease the structural change of the porous structure during the heating process at high temperatures, which is not one especially introduced for the cleaning of the present invention.

The low-temperature-oxidized film is also formed by intrusion of oxide atom into the crystal lattice of substrate surface, similarly as in thermal oxidation, and if the dust particles are present on the surface it will be also formed at the interface between the particles and the substrate. The oxide film is removed from the surface by etching of oxide film together with the dust particles having adhered during the oxidation step.

However, the dust particles will be brought into the etching bath unless the surface of oxide film before etching is clean. It will cause the dust particles to re-adhere to the substrate after etching.

For this reason, the cleaning after the oxidation step is carried out preferably before exfoliation of the oxide film by etching.

Accordingly, in Fig. 14, porous silicon is made hydrophilic by oxidation or the like, thereafter it is subjected to the high-frequency cleaning with pure water to effectively remove the dust particles from the surface and to create a clean oxide film surface, exfoliation of the surface oxide film with the dilute HF solution is carried out immediately before epitaxial growth or the like, and then the epitaxial growth or the like is carried out, thus providing a clean porous silicon surface that can be used in the semiconductor processes.

In addition, the dust particles on the oxide film surface, which might be a cause of re-adhesion of dust particles in the dilute HF etching step, are already removed so as to secure the clean oxide film surface, whereby the dust particles are little brought into the dilute HF liquid bath, thus relieving the problem of re-contamination.

As described, the difference of the fabrication method of Fig. 14 from Fig. 13 is that the high-frequency cleaning with pure water carried out on the hydrophobic surface after the oxide film removing step of porous silicon surface with the dilute HF solution between the thermal oxidation step and the epitaxial growth step is changed to the pure-water high-frequency cleaning carried out on porous silicon having the hydrophilic surface between the oxidation step and the dilute HF etching step.

With this change of timing of cleaning, the dust particles on the porous silicon surface can be removed effectively without a need for the countermeasure against adhesion of bubble, such as the regular substrate lift operation during cleaning or the deaeration of pure water.

The hydrophilic process may be made using the oxidation action with ozone water or hydrogen peroxide water described hereinafter, instead of the thermal oxidation. In this case, though immersion of substrate is sufficient, it is more preferable to apply the high-frequency ultrasonic wave thereto. Examples of the hydrophilic process include dry oxidation processes, such as atmospheric pressure oxidation in a high-concentration ozone gas ambience or in a high-concentration oxidizing ambience, or a process by plasma oxidation under reduced pressure using the aforementioned gas as a base raw material.

On the other hand, there are many dust particles adhering to the hydrophobic surface after anodization. When it is put into a thermal oxidation system, the dust particles, depending upon the types thereof, would come to firmly stick to the surface, and would be a cause of contamination of the oxidation system.

In the fabrication flow shown in Fig. 14, cleaning takes place in combination of the deaeration process of dissolved gas in the pure water with the high-frequency cleaning with pure water of hydrophobic surface (step S₁).

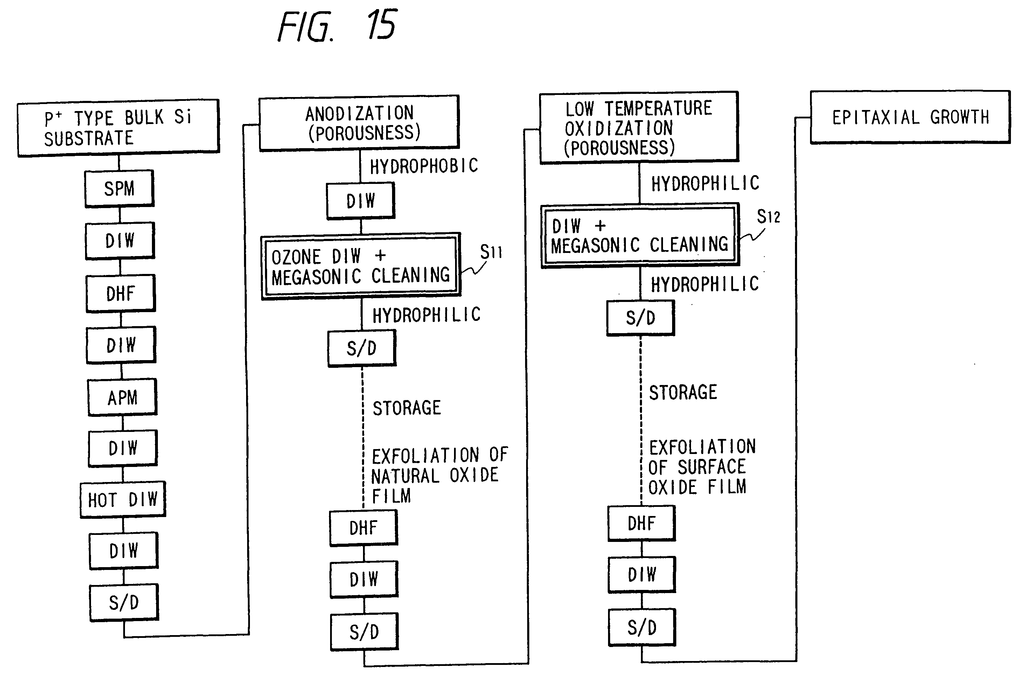

Such a cleaning step including the deaeration process can be replaced by the cleaning method as shown in Fig. 15. In step S₁₁ of Fig. 15 high-frequency cleaning takes place with pure water in which ozone is dissolved.

As well known, the pure water with ozone dissolved therein has strong oxidizing action. The removing effect of organic matter greatly depends upon the oxidizing action of organic matter. The strong oxidizing action of the ozone pure water can be used as the hydrophilic process of hydrophobic surface, and has an effect to create the hydrophilic surface by oxidizing the porous silicon surface after anodization. If the hydrophilic surface thus created is subjected to the high-frequency cleaning, the hydrophilic process and high-frequency cleaning will be performed in one step.

In addition, even if the ozone pure water intrudes into the pores of porous silicon like the pure water, it can be eliminated readily as vapor or oxygen gas by heating after the process, thus leaving no negative effect on the subsequent steps.

The oxide film over the porous silicon surface and over the internal walls of holes made by the ozone water containing ozone in the concentration of about 10 to 13 % is removed by etching with DHF, which was carried out conventionally for the purpose of removing the native oxide film prior to the low-temperature oxidation step.

The high-frequency cleaning with the ozone pure water demonstrates the effect on the hydrophobic porous silicon surface, but no problem will arise if it is applied to cleaning of oxidized porous silicon already having the hydrophilic surface. Accordingly, the cleaning method can be used for cleaning of porous silicon both after anodization and after low-temperature oxidation.

Further, from the viewpoint of the hydrophilic process of porous silicon by wet oxidation, it is also possible to employ high-frequency cleaning with hydrogen peroxide solution (H₂O₂/H₂O) of about 2 % or less diluted with pure water, in addition to the ozone water.

This is also cleaning with chemicals, but hydrogen peroxide can be eliminated readily in the same manner even if it intrudes into the inside of pores of porous silicon. Thus hydrogen peroxide leaves no negative effect on the subsequent steps.

The fabrication flow of Fig. 15 may be modified as shown in Fig. 16 wherein low-temperature oxidation takes place after the high-frequency cleaning with pure water in which ozone is dissolved. An oxide film is formed by the ozone pure water on the porous silicon surface after anodization, and the low-temperature thermal oxidation process achieves uniform oxidation proceeding deeply into the holes of the porous inner walls. In addition, there is no need to dare to remove the oxide film formed by the ozone pure water. Thus, the oxide film exfoliation step before the low-temperature thermal oxidation becomes unnecessary, thus further decreasing the steps as shown in Fig. 16.

It is known that the surface of hydrophobic substrate becomes hydrophilic after APM cleaning, but APM cannot be used for the hydrophilic process of hydrophobic porous silicon as described previously.

### <MANUFACTURE OF A SEMICONDUCTOR DEVICE>

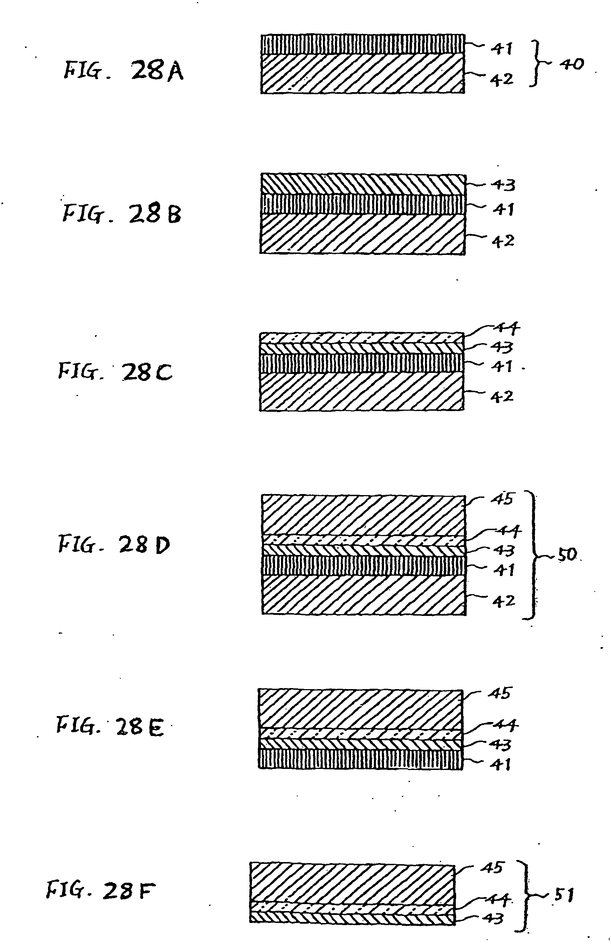

A semiconductor substrate made clean in a manner of the present invention as explained above which substrate has a porous surface may be suitably used for a preparation of a semiconductor device such as MOS-FET. Fig. 28A to 28F are cross-sectional views to schematically show an example of processes of such a semiconductor device.

As shown in Fig. 28A, silicon substrate 40, which has been made clean in the above-explained manner, is comprised of non-porous silicon single crystal region 42 (i.e. bulky silicon region) remaining without being made to be porous and porous silicon single crystal layer 41. First, silicon substrate 40 was heated at 400°C for 1 hour in oxygen atmosphere, whereby oxide films were formed on inner walls of pores of porous silicon single crystal layer 41 and a surface of porous silicon single crystal layer 41, respectively. It is for preventing silicon atoms from a migration in the pore as the result of the raising of temperature in a process of forming an epitaxial layer at a later stage and so forth and the pores from filling up as the result of the migration that the films were provided.

Next, the surface of porous silicon single crystal layer 41 was treated with hydrofluoric acid, to remove the oxide film on the surface of porous silicon single crystal layer 41, leaving the oxide films on the inner walls of the pores. Then, non-porous silicon single crystal layer (epitaxial layer) 43 of 0.3 µm in thickness was made to grow epitaxially on porous Fig.28B. Any of molecular beam epitaxial method, plasma CVD method, reduced pressure CVD method, light CVD method, liquid-phase growth method and sputtering method can be used for forming such non-porous silicon single crystal layers as layer 43. Although it is possible to set up arbitrarily the thickness of non-porous silicon single crystal layer 43 without limiting it to the above-mentioned value, the layer is typically formed in a range of 100 nm through 2 µm in thickness.

Next, as shown in Fig. 28C, the surface of non-porous silicon single crystal layer 43 was partially oxidised, to form oxide film of 200 nm in thickness, as insulating layer 44. Although it is also possible to set up arbitrarily the thickness of insulating layer 44 without limiting it to the above-mentioned value, the layer is typically formed in a range of 50 nm through 2 µm in thickness.

Next, as shown in Fig. 28D, another silicon substrate 45 was laid on top of insulating layer 44 and then the laid faces of them were stuck on each other. Next, the resultant was heat treated at 1180°C for 5 minutes to adhere the faces to each other. As the result, silicon substrate 40 as the first substrate and silicon substrate 45 as the second substrate were adhered to each other through insulating layer 44, so that multi-layer structure 50 wherein non-porous silicon single crystal layer 43 was located was formed as shown in Fig. 28D.

Next, as shown in fig. 28E, non-porous silicon single crystal region 42 was removed from the above-mentioned multi-layer structure 50, to expose porous silicon single crystal layer 41 in a manner as described in the following: First, non-porous silicon single crystal layer 42 was ground by a grinder so as to leave the layer 42 in a slight thickness from the border with porous silicon single crystal layer 41, followed by removing the remaining non-porous silicon single crystal region 42 from by means of dry-etching. Besides such a grinding method, it is able to employ a method of separating non-porous silicon single crystal region 42 from multi-layer structure 50 on the basis of porous silicon single crystal layer 41 as the border. Since the mechanical strength of porous silicon crystal layer 41 is lesser than that of non-porous silicon single crystal region 42, non-porous silicon single crystal layer 43 and so forth, it is possible to separate non-porous silicon single crystal region 42 without causing damage to non-porous silicon single crystal layer 43, by giving between silicon substrate 45 and non-porous silicon single crystal region 42 a force of pulling apart in a direction perpendicular to the surface of the substrate or a shear force in a direction parallel to the surface of the substrate. As an example of other methods of separating non-porous silicon single crystal region 42 capable of being used, methods of inserting a wedge-shaped member or blowing water jet to porous silicon single crystal layer 41 are exemplified. Further, it may be used another method comprised of setting up in advance a region of which the porosity showing a ratio of a volume of pores to a volume of silicon is larger than that of other regions, and then separating non-porous silicon single crystal region 42 using the region as a reparation face. Thus, such methods of separating non-porous silicon single crystal region 42 as mentioned above are capable of baring porous silicon single crystal layer 41 in a short time, so that the semiconductor device can be manufactured efficiently. Further, it can be also used a method comprised of removing from the separated non-porous silicon single crystal region 42 a portion of porous silicon single crystal layer 41 which remains after the separation and than flattening the region as occasion demands, followed by making it porous partially, to utilise non-porous silicon single crystal region 42 as such silicon substrate 40 as shown in Fig.28A.

Next, as shown in Fig. 28F, porous silicon single crystal layer 41 was removed by etching, to form on silicon substrate 45 so-called SOI (silicon-on-insulator) substrate 51, which has thin non-porous silicon single crystal layer 43 through insulating layer 44. A chemical etching method where an aqueous solution containing hydrofluoric acid and hydrogen peroxide water is used as an etchant was employed for the etching of porous silicon single crystal layer 41. The etching rate by such an etchant on porous silicon is 1x10⁵ times greater than that on non-porous silicon. Accordingly, it was able to remove selectively and controllably porous silicon single crystal layer 41, leaving flat non-porous silicon single crystal layer 43 which is uniform in thickness.

Lastly, SOI substrate 51 shown in Fig. 28F was heat treated at 1100°C for lhr in hydrogen atmosphere, to further flatten the surface of non-porous silicon crystal layer 43. Mean square roughness of the surface after this heat treatment measured by interatomic force microscope was about 0.2 nm.

Using non-porous silicon single crystal layer 43 of SOI substrate 51 formed in such a manner as described above, it is capable of manufacturing a semiconductor device such as MOS-FET, DRAM, solar cell and so forth through a well-known semiconductor process.

In the above-mentioned example, it was a silicon substrate that was used as the second substrate. However, also a photo-transmittable substrate such as quartz substrate and glass substrate can be used. When such a photo-transmittable substrate is used therein, the product can be suitably used for photo-sensor, liquid crystal display and so forth. When the second substrate is comprised of an insulating material such as quartz substrate and glass substrate, or when using as the second substrate a silicon substrate wherein an insulating layer such as Si0₂ layer was formed on the adhered face, insulating layer 44 in Fig. 28C is not indispensable. However, if non-porous silicon single crystal layer 43, on which a semiconductor device is to be formed in a future process, should be separated from the adhered face as far as possible to protect it from an influence of an impurity and so forth, it is desirable to form an insulating layer on non-porous silicon single crystal layer 43.

### EXAMPLES

The present invention will be described in further detail with examples.

In the following examples, the pure water used was obtained by treating and filtering service water to satisfy the following conditions of purity.
Resistivity [MΩ.cm] > 17.5
Particle having more than 0.1 µm in diameter [pieces/ml] < 20
Bacteria [pieces/100ml] < 50
Total silica [ppb] < 5
TOC [ppb] < 50
DOC [ppb] < 50
Metallic ion [ppt] < 500

### Examples 1 and 2 are examples of Embodiment 1.

### <Example 1, related to Embodiment 1>

Porous silicon substrates used in cleaning were prepared by forming a porous silicon layer 10 µm thick on one side of p⁺-the 5-inch-diameter silicon substrate RCA-cleaned, by anodization,and then they were subjected to pure-water rinse and spin drying. Then the number of dust particles was measured for each sample using a surface dust particle inspection system.

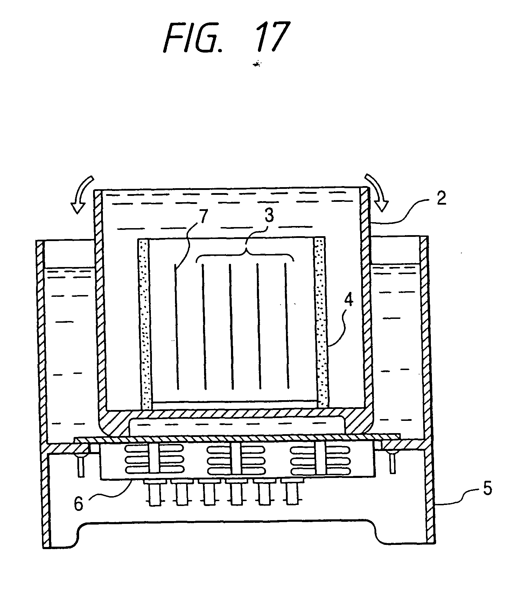

Next, the above porous silicon substrates 3 were set in the order of anodization batches on a cleaning carrier 4 in a Fig. 17. Then they were cleaned as applying the high-frequency ultrasonic wave of the frequency of about 1MHz and the power of 150 W in parallel with the substrates 3 from an oscillator 6 of high-frequency ultrasonic bath 5 through the quartz bath 2.

A bulk silicon substrate 7 RCA-cleaned was placed as a dummy for cleaning at the carrier end, and the substrates were cleaned in the pure water for 20 minutes as eliminating the bubbles adhering thereto by lifting the substrates together with the carrier 4 out of the pure water every five minutes.

For evaluating the removing effect of dust particle, the substrates were subjected to spin drying after cleaning and then measurement of dust particles was carried out. The same cleaning was again conducted for 20 minutes more and then measurement of dust particles was conducted.

The measurement of dust particles was evaluated in the mode to measure dust particles of sizes not less than 0.3 µm, attained from the laser reflection intensity distribution in the 5-inch substrate surface.

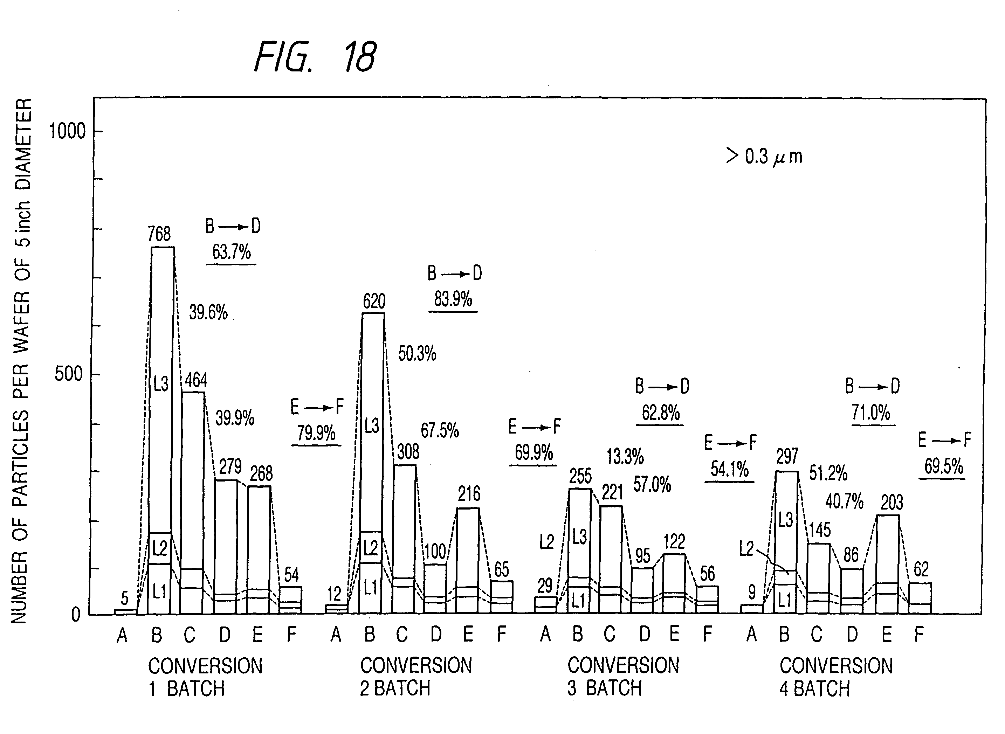

Fig. 18 shows changes in the number of dust particles with this series of cleanings. In this figure values of % indicate removal rates. Fig. 18 does not include data of the dummy 7 at the carrier end.

As shown in Fig. 18, it is seen that the dust particles extremely increase after anodization (indicated by B in the drawing) as compared with the number of dust particles on the substrate surface after RCA cleaning (indicated by A in the drawing) (which is the same data as in Fig. 2 described previously). The classification of L1, L2, and L3 in the bar graph of Fig. 18 indicates rough classification of sizes of dust particles based on laser reflection intensities from the dust particles, and they become greater in the order of L1, L2, and L3 (i.e., L1 < L2 < L3).

Since the dummy substrate was placed at the carrier end, the data of anodization 1 batch was not dependent on contamination from the carrier, but on the order of batch of anodization.

Porous silicon conventionally used was the one cleaned only by pure water rinse and thus having the surface contaminated with dust particles.

When it was cleaned for 20 minutes by the high-frequency ultrasonic cleaning in the pure water according to the present invention (C in the drawing), 13 % to 51 % of dust particles were removed from the surface. Further, the adhering bubbles were eliminated similarly by lifting the substrates together with the carrier 4 every five minutes. The 20-minute cleaning (D in the drawing) removed 63 % to 84 % of dust particles as compared with the data after the pure water rinse (B in the drawing) following anodization. The data of dust particle inspection system after cleaning showed no roughness change due to collapse of porous silicon substrate.

Exclusion of the removal of bubbles resulted in observing the phenomenon that fine dust particles, particularly, of the L1 size collectively adhered to the substrate so as to traverse the substrate along the bubble rise direction (coincident with the ultrasonic propagating direction in the example).

### <Example 2, related to Embodiment 1>

Next described is an example of the high-frequency ultrasonic cleaning after the low-temperature oxidation and the removal of surface oxide layer, which are preliminary treatments indispensable to epitaxial growth on the porous silicon surface.

The porous silicon substrates cleaned by the high-frequency ultrasonic cleaning with pure water after anodization in Example 1 (D in the drawing) were subjected to the low-temperature oxidation in an oxygen ambience at 400°C and for one hour (E in the drawing) and measurement of dust particles was carried out. Then new dust particles adhered thereto as shown in Fig. 18.

The new dust particles adhered in the oxidation furnace and during the operation of the step and, in the case of porous silicon subjected to only the conventional pure water rinse, they were added to the number of dust particles immediately after anodization.

Then the substrates were set on the carrier in the same method as described above and were immersed in diluted hydrofluoric acid. Then the pure-water over-flow high-frequency ultrasonic cleaning was carried out in the cleaning system (Fig. 17) of Example 1 for 20 minutes as eliminating the adhering bubbles by lifting the substrates together with the carrier 4 every five minutes (F in the drawing). As shown in Fig. 18, 54 % to 80 % of dust particles were removed as compared with the data immediately after oxidation and the number of dust particles was not more than 65 in either one of the porous silicon substrates.

This is considered to be the synergistic effect with the removing action to lift off dust particles from the surface in the oxide film exfoliation step. However, only the conventional, diluted hydrofluoric acid and pure water rinse results in detecting approximately several hundred of dust particles, because the dust particles once lifted off re-adhere to the substrate because of the flowing-water charging of hydrophobic substrate. Therefore, the above effect can be considered as a result that the high-frequency ultrasonic cleaning effectively achieved removal of dust particles and prevention of re-adhesion thereof.

In addition, no anomaly was detected on the porous silicon surface after cleaning, as in Example 1.

Now described is the removing effect of adhering bubbles in the high-frequency cleaning in pure water carried out in Example 1 and Example 2.

Adsorption by bubbles is outstanding with fine dust particles and the collectively adhering state thereof to the substrate surface is outstanding. In the ultrasonic cleaning, however, generation of bubbles from dissolved gas in pure water is observed even in the high-frequency band as described previously. When the porous silicon substrate is further dried, bubbles are supposed to be generated because the gas (air) in the pores thereof are replaced with pure water to be discharged out of the pores. In order to clarify what is the origin of the bubbles adhering to the substrate surface, evaluation thereof was conducted by the dust particles not less than 0.2 µm on a hydrophobic bulk substrate surface without any porous structure formed therein.

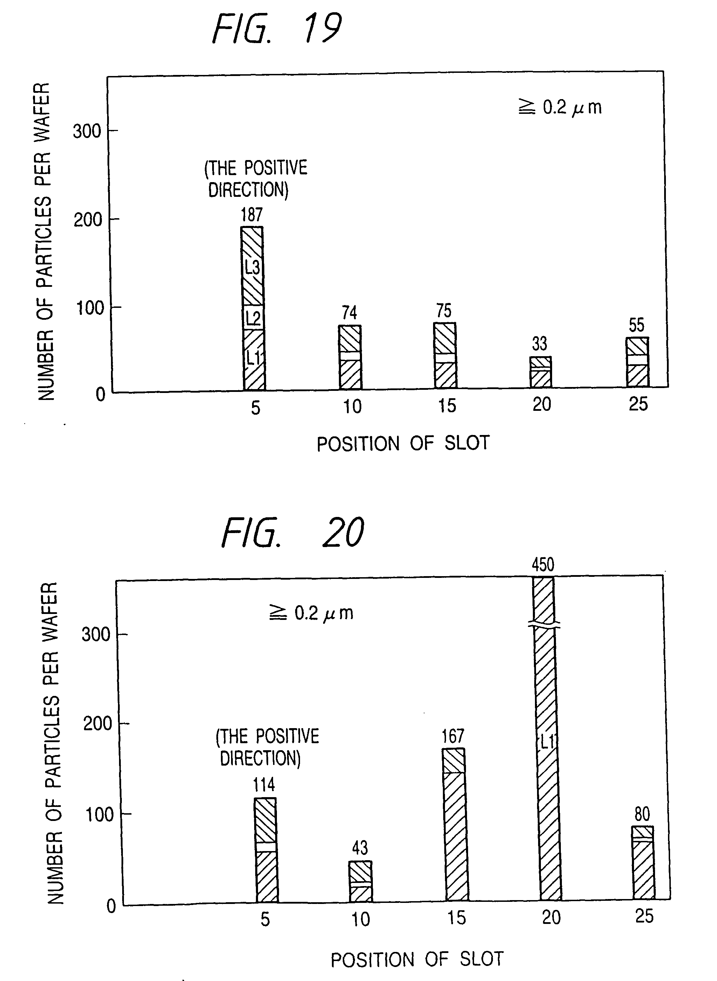

Fig. 19 is a drawing to show the result of measurement of the number of dust particles conducted in such a way that bulk substrates were preliminarily cleaned by RCA cleaning to minimize the number of dust particles on the surface, they were immersed in diluted hydrofluoric acid, thereafter they were rinsed with pure water for 5 minutes, they were dried by spin drying, and then the number of dust particles was measured. It is apparent that the number of dust particles on the substrate at the carrier end is larger than those on the substrates at the other positions. This is considered to be due to inductive charging of the closest wafer induced by carrier charge, as well known. Numbers indicating slot positions in the drawing represent slot numbers of the wafer carrier frequently used heretofore in the semiconductor industrial fields, and slots are formed at equal intervals of the pitch of 5 mm from 1 to 25 from the carrier end.

Fig. 20 is a drawing to show numbers of dust particles where the high-frequency cleaning of the frequency 1 MHz and the power 150 W was carried out in the above five-minute pure-water rinse step. As shown in Fig. 20, the high-frequency cleaning decreases the number of dust particles on the substrate, but, depending upon the slot position of wafer carrier, some substrates show an extreme increase of fine dust particles (L1) on the contrary.

The increased dust particles aggregated densely in parallel to the bubble rise direction and the ultrasonic propagating direction from the slot position in the carrier and from the position distribution in the substrate.

This proves that simple ultrasonic cleaning in pure water results in contaminating the substrate with dust particles against the purpose.

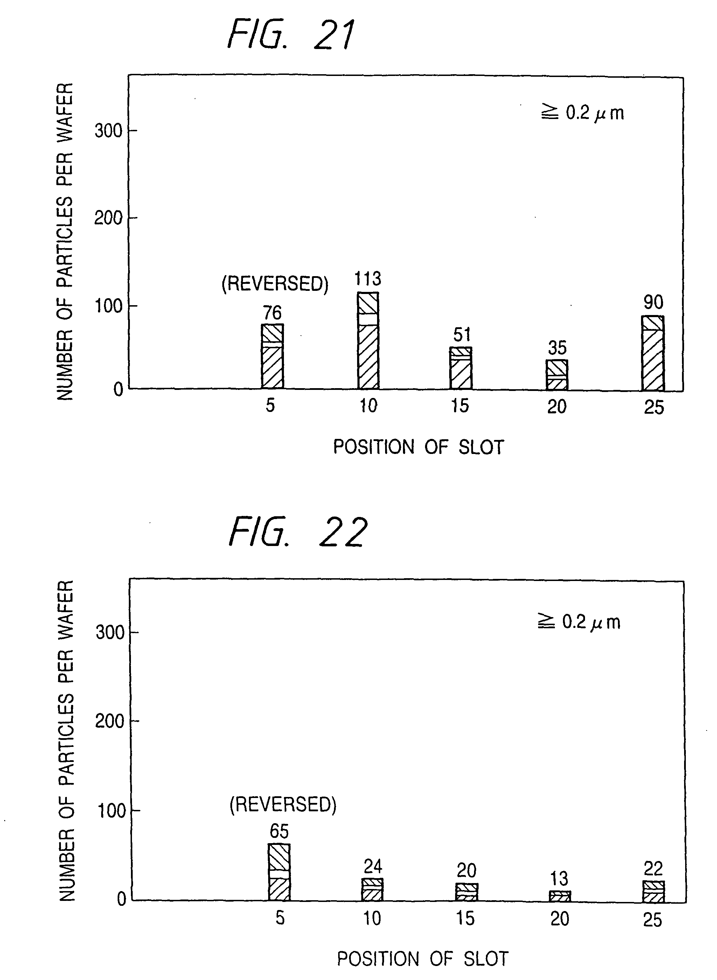

Fig. 21 is a drawing to show numbers of dust particles where only the dust particle measuring surface of the substrate at the carrier end was reversely set with respect to the carrier side, the other wafers in the carrier were normally set, and removal of bubbles was conducted by repeating the operation of lifting the substrates together with the carrier out of the high-frequency pure water bath every five minutes and again immersing them into the pure water, for 20 minutes.

Although the effect by the cleaning time did exist, the removal of bubbles decreased the number of dust particles at each position in the carrier to the level equivalent to those with the pure-water rinse after RCA cleaning (Fig. 19), when compared with Fig. 20, and suppressed the aggregation of dust particles in the substrate.

It became clear from the above results that the cause of contamination of substrate by dust particles was generation of bubbles and adhesion thereof to the hydrophobic substrate surface due to the high-frequency ultrasonic wave from pure water.

From this, though the substrates were lifted up out of the pure water every five minutes in the above examples, the cleaning effect can be enhanced further by repeating the lift operation of substrate every short time within the same cleaning period so as to further decrease the number of adhering bubbles in the cleaning period of time in pure water.

The dust particles on the reversed substrate at the carrier end also decreased similarly, and it will be clarified whether this is due to only the high-frequency cleaning or due to the synergistic effect with the reverse setting.

Bulk substrates each at the carrier end were normally and reversely set and were subjected to the RCA cleaning with the highest cleaning performance, and then the number of dust particles not less than 0.2 µm was counted on each substrate.

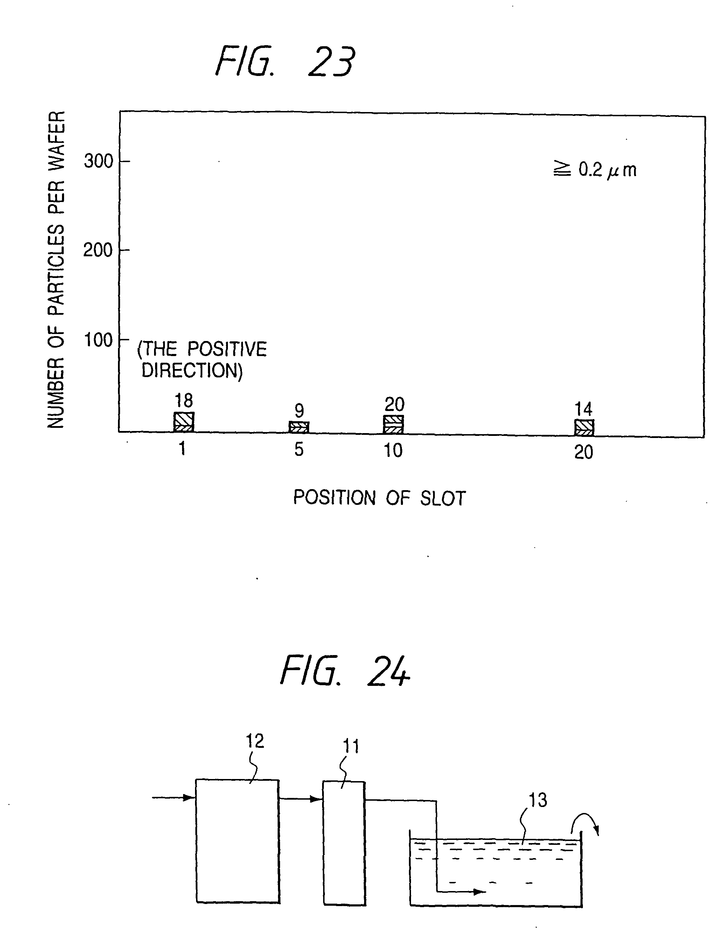

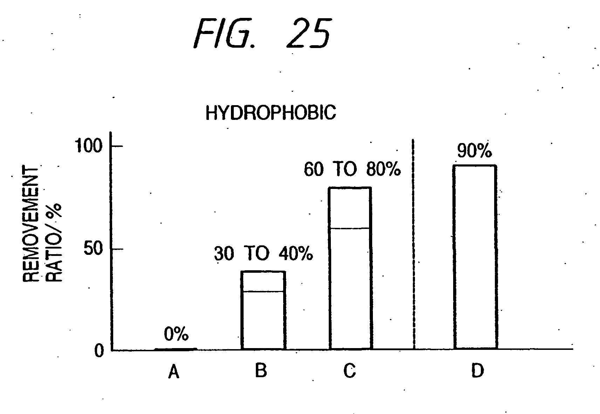

Fig. 22 shows the numbers of dust particles after cleaning in the normal state and Fig. 23 shows the numbers of dust particles after cleaning which was conducted with the bulk substrate being set in the reverse state in the slot at the carrier end where the influence of inductive charging was greater from the carrier.

In the normal state the number of particles on the substrate at the carrier end is prominent as in the case of immersion in diluted hydrofluoric acid, but in the case of the reverse setting, the number is so small as to show little difference when compared with those of the other substrates.

From this, it is understood that the effect of prevention of adhesion by the setting method is also included in the decrease of number of dust particles after the high-frequency cleaning of reversely set substrate in Fig. 21.

As described, for carrying out the high-frequency cleaning in the batch-type bath, consideration should be given to the setting method of the substrate at the carrier end and the prevention of adhesion of bubble.

The above examples were described as specific examples using the batch-type cleaning apparatus, but it is noted that the cleaning effect of the present invention is not limited by the configuration of apparatus.

Similarly, the conditions including the frequency and high-frequency power, the cleaning period of time, the temperature of liquid, etc. are just an example for verifying the cleaning effect of the present invention, and the present invention is limited only by the frequency band (from 600 kHz to 2 MHz), but the other conditions can be set arbitrarily.

Specifically, in the above described examples, of the present invention the high-frequency wave was superimposed on pure water, but, from the fact that the removing effect of organic matter and dust particles is well known where a small amount of surfactant, ozone, or the like is added to the pure water, methods in combination of these with the high-frequency cleaning of porous silicon surface specific to the present invention can be readily achieved

### <Example 3, related to Embodiment 1>

A film deaeration apparatus 11 in Example 3 is used as connected midway of a pure water supply pipe between the conventional pure water producing apparatus 12 and the ultrasonic cleaning apparatus 13. The pure water produced by the film deaeration apparatus 11 is desirably released from the bottom part of the ultrasonic cleaning apparatus 13 in order to avoid take-in of air.

This permits the pure water of the concentration of dissolved gas being 5 ppm or less to be supplied to the ultrasonic cleaning apparatus 13.

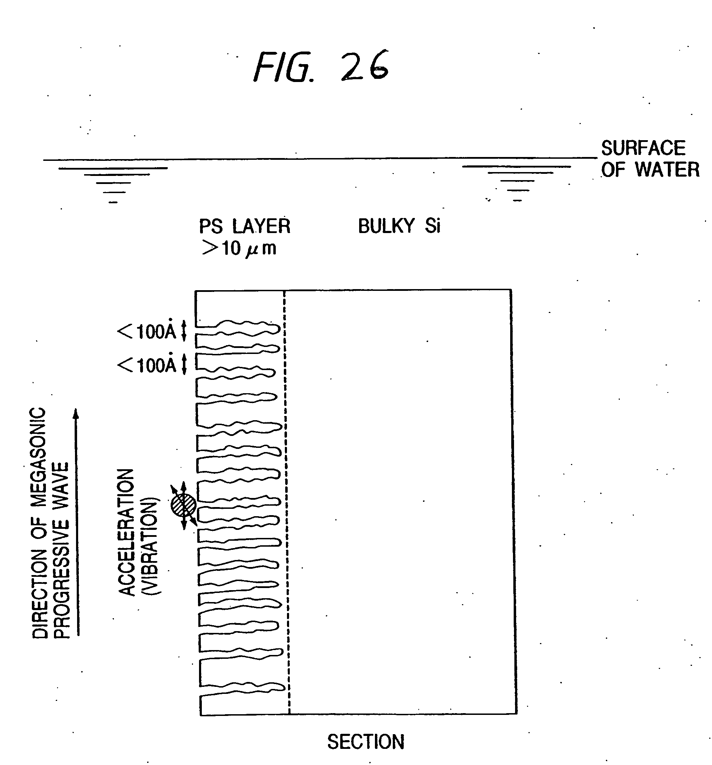

Porous silicon substrates each having a hydrophobic surface obtained by removing the surface native oxide film were set on the cleaning carrier in a quartz bath under over flow of flowing water, using deaerated pure water, and the ultrasonic cleaning (the frequency 950 kHz) was conducted as applying the high-frequency ultrasonic wave of power 150 W in parallel to the substrate from the oscillator of the high-frequency ultrasonic bath through the quartz bath during immersion for 20 minutes. The cleaning was carried out only by immersion without performing the lift operation of substrate. Fig. 26 schematically shows the relationship between the porous silicon substrate and the high-frequency progressive wave. The removing effect of dust particles adhering to the porous silicon substrate can be enhanced by placing the cleaned surface of porous silicon substrate in parallel with the travel direction of the high-frequency progressive wave as shown.

With the deaerated pure water, generation of bubble due to application of high-frequency ultrasonic wave was not observed at all and fixing of bubble to the substrate surface was not observed, either.

Fig. 25 shows comparison of dust particle removal rates of porous surface among the case of the conventional high-frequency cleaning (case B) where cleaning was continued for 20 minutes under the same ultrasonic conditions by using non-deaerated pure water and performing the substrate lift operation every five minutes, the conventional case (case C) where the same cleaning was further continued for 20 minutes more (for 40 minutes in total), and the case (case A) where cleaning was conducted under the above cleaning conditions of the present invention for only immersion in deaerated pure water.

The removal rate by the 20-minute high-frequency cleaning of the present invention (case D) reaches 90 %, which is more excellent than the 40-minute cleaning (60 to 80 %) by the high-frequency cleaning with non-deaerated pure water (where N₂ is in the saturation concentration) (case C).

### <Example 4 related to Embodiment 2>

Examples 4 to 6 are examples of Embodiment 2. The cleaning flow of Example 4 up to the epitaxial growth of porous silicon substrate is the same as the cleaning flow shown in Fig. 13. However, the cleaning steps S₂, S₃ are omitted in this example. When a demand exists for a further decrease in the number of adhering dust particles, the cleaning steps S₂, S₃ can be performed with necessity, of course.

Since the surface is hydrophobic immediately after anodization, adhesion of bubbles to the substrate is avoided by carrying out, during the high-frequency cleaning with pure water, the deaeration process of pure water.

Cleaning was conducted to process one dummy substrate at the end of polytetrafluoroethylene (Teflon) carrier for cleaning and twenty four porous silicon substrates together and was continued for 20 minutes under the conditions of the frequency of 950 kHz, the high-frequency power 150 W, the ordinary temperature, and over flow of flowing water with the substrates being kept immersed.

The pure water was one deaerated before the concentration of dissolved gas became 5 ppb or less (step S₁). This cleaning removed almost 90 % of dust particles which have adhered in the anodization step.

The porous silicon surface thus cleaned is hydrophobic, but a native oxide film is formed thereon during the period of storage. Accordingly, immediately before the low-temperature oxidation process, the high-frequency cleaning with pure water and the exfoliation of the native oxide film with DHF were conducted again, and a thermal oxide film was formed in dry oxygen, at the low temperature of 400°C, and for one hour.

The surface after the low-temperature oxidation becomes hydrophilic, but approximately 100 dust particles newly adhere to the substrate surface during the oxidation step. Therefore, the high-frequency cleaning with pure water was carried out after the oxidation to remove the dust particles on the surface and to create a clean oxide film surface, and the substrates were stored in a dedicated box.

Since the porous silicon surface after oxidation is hydrophilic, the countermeasure to prevent the bubbles from adhering to the substrate surface is unnecessary and the substrates can be cleaned as immersed in the high-frequency cleaning bath with non-deaerated pure water.

The substrates were cleaned for 20 minutes under the cleaning conditions of the frequency of 950 kHz, the high-frequency power 150 W, the ordinary temperature, and immersion in the flowing water over-flow bath, using the non-deaerated pure water and keeping the substrates immersed.

This cleaning removed 90 % of dust particles which have adhered in the oxidation step. Storage after oxidation and cleaning, even if long, raises no problem at all in applications of porous silicon, because it is covered by the oxide film.

The porous silicon substrates with the oxide film, having been stored, of the number that could be processed by the epitaxial growth system were subjected to exfoliation removal of only the oxide film on the porous silicon surface with DHF immediately before introduced into the epitaxial growth system, and then epitaxial growth was conducted.

At this time the epitaxial growth made a film with the surface of porous silicon as the origin, and therefore, the oxide film over the internal walls of holes of porous silicon were left in the etching step with DHF.

Two types of pure water used in the above high-frequency cleaning with pure water, deaerated and non-deaerated, were used depending upon the surface state of substrate, but the deaerated pure water may be used for both the hydrophobic surface (after anodization) and the hydrophilic surface (after low-temperature oxidation) or the lift operation of substrate (without deaeration) may be carried out.

### <Example 5, related to Embodiment 2>

Next described is the invented cleaning method of porous silicon substrate before the epitaxial growth.

Fig. 15 shows the cleaning flow of the present example. The high-frequency cleaning with deaerated pure water was carried out to clean the hydrophobic porous silicon surface after anodization in above Example 1, whereas in the present example the high-frequency cleaning was carried out under the same conditions using ozone pure water in which ozone dissolved in approximately 10 to 13 %.

The ozone pure water used herein was the one obtained by dissolving ozone gas, obtained from a wet type ozone producing system in combination of a hollow fiber filter with electrolysis of pure water as well known, in pure water.

The oxide film formed over the surface of porous silicon and the internal walls of holes by the ozone pure water after anodization is removed by etching with DHF immediately before the low-temperature oxidation step, similar to that heretofore.

Use of the ozone pure water requires addition of new apparatus, but it is easier to control the concentration in the cleaning bath than deaeration of pure water.

In the present example, because the oxide film was already formed so as to be hydrophilic, the high-frequency cleaning was conducted using non-deaerated pure water as the high-frequency cleaning after the low-temperature oxidation, but no problem will arise even with the high-frequency cleaning using the ozone pure water (step S₁₂ of Fig. 15 can be performed under the same conditions as in step S₁₁).

### <Example 6 related to Embodiment 2>

Still another example of the present invention will be described.

The cleaning flow is the same as in Example 5, but it was modified, though not illustrated, to a method of high-frequency cleaning after the hydrophobic porous silicon surface after anodization was made hydrophilic with hydrogen peroxide solution (H₂O₂/H₂O) of a low concentration of approximately 2 % or less diluted with pure water, instead of the high-frequency cleaning carried out after the hydrophobic porous silicon surface after anodization has been changed to the hydrophilic surface with the ozone pure water.

The cleaning method demonstrated the cleaning effect even with keeping the substrate immersed, similarly as in use of the deaerated pure water or the ozone pure water.

In general, when chemicals are used, cleaning is carried out with the chemicals kept in the cleaning bath. However, the dust particles removed do not dissolve in the chemicals and stay in the bath in the cleaning method of the present invention.

Therefore, the pure water used in cleaning in the present example was subject to over flow of flowing water, the dust particles removed were discharged with water out of the cleaning bath, the diluted hydrogen peroxide solution thus discharged was guided through a filter for capturing particles of about 0.1 µm, then the hydrogen peroxide solution was recirculated to the cleaning bath, and the high-frequency cleaning was conducted as thus supplying the hydrogen peroxide solution. A certain amount of hydrogen peroxide was regularly replenished to compensate for consumption thereof.

## Claims

1. A method of cleaning a substrate having a porous silicon layer on a surface thereof, comprising the step of:
applying a high-frequency wave with a frequency in the range of from 600 kHz to 2 MHz to the substrate in a direction parallel to the surface of the porous silicon layer while immersing the substrate in a liquid selected from pure water and water containing substantially only ozone or hydrogen peroxide, to remove dust particles adhering to the porous silicon layer.

2. The method of cleaning a substrate according to claim 1, wherein said porous silicon layer has a hydrophobic surface just prior to being cleaned by said cleaning method.

3. The method of cleaning a substrate according to claim 1, wherein internal wall surfaces of pores of said porous silicon layer are covered with a material of a different kind just prior to being cleaned by said cleaning method.

4. The method of cleaning a substrate according to claim 1, wherein just prior to being cleaned (S₁₂) by said cleaning method pores of said porous silicon layer have hydrophilic internal wall surfaces, which surfaces have been covered with silicon oxide by oxidising (S₁₁) a porous silicon layer having a hydrophobic surface formed by anodisation.

5. The method of cleaning a substrate according to claim 1, wherein the concentration of nitrogen dissolved in said pure water is 5 ppm or less.

6. A method of fabricating a semiconductor substrate which comprises the steps of:
forming a porous silicon layer (41) on a silicon substrate (42) by anodisation,
forming an oxide film on internal wall surfaces of pores of the porous silicon layer,
growing a single crystal layer (43) epitaxially on the porous silicon layer,
wherein the porous silicon layer is cleaned by the cleaning method according to claim 1 after the step of forming the porous silicon layer and before the step of growing the single crystal layer epitaxially.

7. The method of fabricating a semiconductor substrate according to claim 6, wherein said semiconductor substrate is an SOI substrate.

8. A method of manufacturing a semiconductor device comprising steps of:
cleaning the porous silicon layer (42) on the surface of a substrate (41) by the cleaning method according to claim 1;
preparing the cleaned substrate for semiconductor device processing; and
processing the prepared substrate to produce a semiconductor device.

9. The method according to claim 8, wherein the cleaned substrate comprises successive layers of non-porous and porous silicon, respectively, and the cleaned substrate is prepared by steps of:
forming a surface film of silicon oxide at the pore walls and exposed surface of said porous silicon layer (42);
removing said oxide film formed at the surface of said porous silicon layer;
growing an epitaxial layer (43) of non-porous silicon on the surface of said porous silicon layer;
forming a surface film (44) of silicon oxide on said epitaxial layer;
bonding a second substrate (45) to said surface film of silicon oxide formed on said epitaxial layer; and
removing said layers of non-porous (41) and porous (42) silicon comprising said cleaned substrate, to expose a surface of said epitaxial layer (43) for the subsequent semiconductor device processing.

## Patentansprüche

1. Verfahren zur Reinigung eines Substrats, das eine poröse Siliciumschicht auf seiner Oberfläche aufweist, das den folgenden Schritt aufweist:
Anlegen einer hohen Frequenzwelle mit einer Frequenz im Bereich von 600 kHz bis 2 MHz an das Substrat in einer Richtung parallel zur Oberfläche der porösen Siliciumschicht, während das Substrat in eine Flüssigkeit eingetaucht wird, die aus reinem Wasser und Wasser ausgewählt wird, das im wesentlichen nur Ozon oder Wasserstoffperoxid enthält, um Staubteilchen zu entfernen, die auf der porösen Siliciumschicht haften.

2. Verfahren zur Reinigung eines Substrats nach Anspruch 1, wobei die poröse Siliciumschicht eine hydrophobe Oberfläche, gerade bevor durch dieses Reinigungsverfahren gereinigt wird, aufweist.

3. Verfahren zur Reinigung eines Substrats nach Anspruch 1, wobei die Oberflächen der inneren Wand der Poren von dieser porösen Siliciumschicht mit einem Material von einer anderen Art, gerade bevor durch dieses Reinigungsverfahren gereinigt wird, bedeckt sind.

4. Verfahren zur Reinigung eines Substrats nach Anspruch 1, wobei gerade bevor (S₁₂) durch dieses Reinigungsverfahren gereinigt wird, die Poren von dieser porösen Siliciumschicht hydrophile Oberflächen der inneren Wand aufweisen, deren Oberflächen mit Siliciumoxid durch Oxidation (S₁₁) einer porösen Siliciumschicht bedeckt sind, die eine hydrophobe Oberfläche aufweist, die durch Anodisierung gebildet ist.

5. Verfahren zur Reinigung eines Substrats nach Anspruch 1, wobei die Konzentration des Stickstoffs, der im reinen Wasser gelöst ist, 5 ppm oder weniger beträgt.

6. Verfahren zur Herstellung eines Halbleitersubstrats, das die folgenden Schritte aufweist:
Bildung einer porösen Siliciumschicht (41) auf dem Siliciumsubstrat (42) durch Anodisierung,
Bildung eines Oxidfilms auf der inneren Wand der Oberflächen der Poren der porösen Siliciumschicht,
epitaxiales Wachsenlassen einer einkristallinen Schicht (43) auf der porösen Siliciumschicht,
wobei die poröse Siliciumschicht durch ein Reinigungsverfahren nach Anspruch 1 nach dem Schritt der Bildung der porösen Siliciumschicht und vor dem Schritt des epitaxialen Wachsenlassen der einkristallinen Schicht gereinigt wird.

7. Verfahren zur Herstellung eines Halbleitersubstrats nach Anspruch 6, wobei das Halbleitersubstrat ein SOI Substrat ist.

8. Verfahren zur Herstellung einer Halbleitervorrichtung, das die folgenden Schritte aufweist:
Reinigung der porösen Siliciumschicht (42) auf der Oberfläche eines Substrats (41) durch das Reinigungsverfahren nach Anspruch 1;
Bereitstellung des gereinigten Substrats für die Verarbeitung der Halbleitervorrichtung; und
Verarbeitung des bereitgestellten Substrats, um eine Halbleitervorrichtung herzustellen.

9. Verfahren nach Anspruch 8, wobei das gereinigte Substrat aufeinander folgende Schichten jeweils des nicht porösen und porösen Siliciums aufweist und das gereinigte Substrat durch die folgenden Schritte hergestellt wird:
Bildung eines Oberflächenfilms aus Siliciumoxid an den Porenwänden und der exponierten Oberfläche dieser porösen Siliciumschicht (42);
Entfernen des Oxidfilms, der auf der Oberfläche der porösen Siliciumschicht gebildet ist;
Wachsenlassen einer epitaktischen Schicht (43) auf nicht porösen Silicium auf der Oberfläche der porösen Siliciumschicht;
Bildung eines Oberflächenfilms (44) aus Siliciumoxid auf der epitaktischen Schicht;
Boden eines zweiten Substrats (45) auf dem Oberflächenfilm des Siliciumoxids, das auf der epitaktischen Schicht gebildet ist und
Entfernen der Schichten aus nicht porösem (41) und porösem (42) Silicium, das das gereinigte Substrat aufweist, um eine Oberfläche von der epitaktischen Schicht (43) für die darauf folgenden Verarbeitung der Halbleitervorrichtung zu exponieren.

## Revendications

1. Procédé pour le nettoyage d'un substrat comprenant une couche de silicium poreuse sur une de ses surfaces, comprenant les étapes consistant :
à appliquer une onde haute fréquence, à une fréquence comprise dans l'intervalle de 600 kHz à 2 MHz au substrat dans une direction parallèle à la surface de la couche de silicium poreuse, tout en immergeant le substrat dans un liquide choisi entre l'eau pure et de l'eau contenant pratiquement seulement de l'ozone ou du peroxyde d'hydrogène, pour éliminer les particules de poussière adhérant à la couche de silicium poreuse.

2. Procédé de nettoyage d'un substrat suivant la revendication 1, dans lequel ladite couche de silicium poreuse a une surface hydrophobe juste avant d'être nettoyée par ledit procédé de nettoyage.

3. Procédé de nettoyage d'un substrat suivant la revendication 1, dans lequel les surfaces des parois intérieures des pores de ladite couche de silicium poreuse sont couvertes d'une matière d'un type différent juste avant d'être nettoyées par ledit procédé de nettoyage.

4. Procédé de nettoyage d'un substrat suivant la revendication 1, dans lequel, juste avant son nettoyage (S₁₂) par ledit procédé de nettoyage, les pores de ladite couche de silicium poreuse ont des surfaces de parois intérieures hydrophiles, surfaces qui ont été couvertes d'oxyde de silicium en oxydant (S₁₁) une couche de silicium poreuse ayant une surface hydrophobe formée par anodisation.

5. Procédé de nettoyage d'un substrat suivant la revendication 1, dans lequel la concentration d'azote dissous dans ladite eau pure est égale ou inférieure à 5 ppm.

6. Procédé pour la fabrication d'un substrat à semi-conducteurs, qui comprend les étapes consistant :
à former une couche de silicium poreuse (41) sur un substrat en silicium (42) par anodisation,
à former un film d'oxyde sur les surfaces de parois intérieures des pores de la couche de silicium poreuse,
à faire croître une couche monocristalline (43) de manière épitaxiale sur la couche de silicium poreuse,
dans lequel la couche de silicium poreuse est nettoyée par le procédé de nettoyage suivant la revendication 1 après l'étape de formation de la couche de silicium poreuse et avant l'étape de croissance épitaxiale de la couche monocristalline.

7. Procédé de fabrication d'un substrat à semi-conducteurs suivant la revendication 6, dans lequel ledit substrat à semi-conducteurs est un substrat SOI.

8. Procédé de production d'un dispositif semi-conducteur, comprenant les étapes consistant :
à nettoyer la couche de silicium poreuse (42) sur la surface d'un substrat (41) par le procédé de nettoyage suivant la revendication 1 ;
à préparer le substrat nettoyé pour le traitement à des fins de production du dispositif semi-conducteur ; et
à traiter le substrat préparé pour produire un dispositif semi-conducteur.

9. Procédé suivant la revendication 8, dans lequel le substrat nettoyé comprend des couches successives de silicium non poreux et de silicium poreux, respectivement, et le substrat nettoyé est préparé par les étapes consistant :
à former un film de surface d'oxyde de silicium au niveau des parois des pores et de la surface exposée de ladite couche de silicium poreuse (42) ;
à éliminer ledit film d'oxyde formé à la surface de ladite couche de silicium poreuse ;
à faire croître une couche épitaxiale (43) de silicium non poreux sur la surface de ladite couche de silicium poreuse ;
à former un film de surface (44) d'oxyde de silicium sur ladite couche épitaxiale ;
à lier un second substrat (45) audit film de surface d'oxyde de silicium formé sur ladite couche épitaxiale ; et
à éliminer lesdites couches de silicium non poreux (41) et de silicium poreux (42) constituant ledit substrat nettoyé, pour exposer une surface de ladite couche épitaxiale (43) pour le traitement suivant de formation de dispositif semi-conducteur.
